# EUROPÄISCHE PATENTSCHRIFT

(11) **EP 1 062 689 B1**
(45) Veröffentlichungstag und Bekanntmachung des Hinweises auf die Patenterteilung: **09.09.2009**
(21) Anmeldenummer: 99920548.7
(22) Anmeldetag: 14.03.1999
(51) Int. Cl.: H01L 31/05, H01L 31/0352

(54) **SOLARZELLENANORDNUNG UND VERFAHREN ZUR HERSTELLUNG EINER SOLARZELLENANORDNUNG**
SOLAR CELL ARRANGEMENT AND METHOD OF MAKING A SOLAR CELL ARRANGEMENT
CONFIGURATION DE CELLULE SOLAIRE ET PROCÉDÉ DE FABRICATION D'UNE CONFIGURATION DE CELLULE SOLAIRE

(30) Priorität: 13.03.1998 DE 19810904; 04.06.1998 DE 19824837; 13.08.1998 DE 19836733
(43) Veröffentlichungstag der Anmeldung: 27.12.2000
(73) Patentinhaber: Fath, Peter, Dr., 78467 Konstanz (DE); Willeke, Gerhard, Dr., 78465 Konstanz (DE)
(72) Erfinder: KELLER, Steffen, Dr., 76133 Karlsruhe (DE); FATH, Peter, Dr., 78467 Konstanz (DE); WILLEKE, Gerhard, Dr., 78465 Konstanz (DE)
(74) Vertreter: Pietruk, Claus Peter
(86) Internationale Anmeldenummer: PCT/DE1999/000728
(87) Internationale Veröffentlichungsnummer: WO 1999/048136

(56) Entgegenhaltungen:
- US-A- 4 144 096
- US-A- 4 352 948
- US-A- 4 612 408
- US-A- 5 164 019
- US-A- 5 391 236
- US-A- 5 538 902
- J. M. GEE ET AL.: "Simplified module assembly using back-contact crystalline-silicon solar cells" 26TH IEEE PHOTOVOLTAIC SPECIALISTS CONFERENCE,29. September 1997 (1997-09-29) - 3. Oktober 1997 (1997-10-03), Seiten 1085-1088, XP002113189 ANAHEIM, USA
- A. SCHÖNECKER ET AL.: "An industrial multi-crystalline EWT solar cell with screen printed metallisation" 14TH EUROPEAN PHOTOVOLTAIC SOLAR ENERGY CONFERENCE, Bd. 1, 30. Juni 1997 (1997-06-30) - 4. Juli 1997 (1997-07-04), Seiten 796-799, XP002113190 BARCELONA, ES

## Beschreibung

Die vorliegende Erfindung betrifft ein Verfahren und eine Vorrichtung nach den jeweiligen Oberbegriffen der unabhängigen Ansprüche. Die Erfindung befaßt sich somit mit einer Solarzellenanordnung.

Für Solarzellenanordnungen gibt es eine Vielzahl von Anwendungen. Einerseits werden großflächige Solarzellenanordnungen in Photovoltaikanlagen eingesetzt, die für größere Verbraucher hinreichend viel Energie zur Verfügung stellen können; hier spielen die Kosten der Zellen oft eine untergeordnete Rolle, weil sie etwa gegen die andernfalls aufzubringenden Kosten für einen Anschluß an ein öffentliches Versorgungsnetz nicht wesentlich ins Gewicht fallen, oder weil es, wie beim Einsatz in der Raumfahrt, keine sinnvolle Alternative gibt.

Andererseits finden sich Solarzellenanordnungen auch in einer Vielzahl von z.Zt. leistungsschwachen Klein-Geräten wie Taschenrechnern und Armbanduhren. Es ist aber prinzipiell denkbar, Solarzellenanordnungen auch in Geräten der Konsumgüter-Elektronik mit geringfügig höherem Leistungsbedarf als Taschenrechner oder Uhren zu verwenden. So kann erwogen werden, Solarzellenanordnungen etwa zum vom Netz autarken Laden und Betreiben tragbarer Computer und Funktelefone zu benutzen, wo Betriebsspannungen zwischen 6 und 12 V üblich sind.

Technisch ist dies möglich, da z.B. ein Funktelefonakku, der ca. 2 Watt für ein Gespräch zur Verfügung stellt, eine Ladespannung von ca. 7 Volt und eine Gesamtladung von etwa 550mAh bis 1200mAh benötigt. Um das Handy durch bloße Sonneneinstrahlung funktionstüchtig zu erhalten, steht auf der Rückseite eine Fläche von ca. 50cm² zur Verfügung. Mit Solarzellenanordnungen in Siliziumtechnologie sind bei dieser Fläche unter der Annahme eines Wirkungsgrades von nur etwa 14% und kleinen Reihenschaltungsverlusten eine Spannung von über ca. 7 Volt und Ströme von mehr als 100mA am Punkt maximaler Leistung (maximum power point) erreichbar, so daß es prinzipiell möglich ist, durch hinreichend lange Sonneneinstrahlung ein Laden zu ermöglichen.

Die einzusetzenden Zellen dürfen aber weder Größe und Handlichkeit beeinträchtigen, noch dürfen sie zu teuer sein, um im Konsumgüterbereich Einsatz zu finden. Zur Erfüllung der ersten Forderung müssen recht kleine Solarzellen von wenigen Quadratzentimeter miteinander verschaltet werden, was anstelle der bei Photovoltaikanlagen üblichen, großflächigen Solarzellenmodulen Kleinstmodule erfordert. Diese müssen dann kostengünstig montiert werden.

Bislang scheitert der Einsatz von Solarzellenanordnungen oft noch an den zu hohen Kosten. Dies war auch bedingt durch die hohen Kosten der Serien- d.h. Reihenverschaltung. Bei der Reihenverschaltung muß prinzipiell die Basis der ersten Zelle mit dem Emitter der zweiten Zelle leitend verbunden werden. Die Basis ist typisch auf der einen Solarzellenfläche, der Emitter auf der gegenüberliegenden Oberfläche angeordnet.

Werden Solarzellen auf der Basis kristalliner Siliziumwafer für die Solarzellenanordnungen verwendet, so bestehen im Stand der Technik prinzipiell mehrere Möglichkeiten, die Reihenschaltung zu erzielen. So kann die Zellenvorderseite einer Solarzelle mit den Zellenrückseite der nächsten Zelle über verzinnte Kupferbänder oder dergl. elektrisch leitend verbunden werden. Weiter ist es aus K.J. Euler, "Energie- Direktumwandlung", Verlag Karl Thiemig KG, München, 1967, S.55 bekannt, die einzelnen Solarzellen wie Schindeln oder Dachziegel leicht überlappend anzuordnen und dann den Basisrückkontakt der einen Zelle mit dem Emitterfrontkontakt auf der nächsten Zelle elektrisch zu verbinden.

Aus dem Aufsatz "Emitter Wrap-Through Solar Cell" von J. M. Gee et al., Proc. 23.rd IEEE PVSC, Louisville, 1993, S. 265-270 ist es bekannt, eine Solarzelle mit einem Vorder- und Rückseitenemitter des n+Typus zu versehen, der ein p-dotiertes Basismatieral umgibt. Während der Vorderseitenemitter nur mit einem Antireflexüberzug versehen sein muß, sind auf der Rückseite zwei Kontaktgitter vorgesehen, nämlich eines vom p- Typus zur Kontaktierung der Basis und eines vom n-Typus zur Kontaktierung des Emitters respektive. Beide Gitter bilden ein Muster ineinandergreifender Finger, die an einem Ende über Sammelschienen, sog. Busbars verbunden sind. Um den Vorderseitenemitter mit dem Rückseitenemitter bzw. dem dort verlaufen Emitter-Kontaktgitter zu verbinden, werden Löcher mit Laserpulsen in das Substrat eingebracht, dotiert und mit einem selektiven Verfahren mit Metall aufgefüllt, um so eine leitende Verbindung herzustellen. Die Schrift befaßt sich zwar mit dem Reihenwiderstand eines einzelnen Elementes, gibt aber nicht an, wie mehrere Zellen auf günstige Weise miteinander verschaltet werden sollen.

Es ist weiter vorgeschlagen worden in dem im Internet veröffentlichten Aufsatz "The crystalline-silicon photovoltaic R & D project at NREL and SNL", J. M. Gee und T. F. Ciszek, AIP Conference Proceedings 1997, AIP USA, vol. TAICS, no. 394, p. 189-197, ein Modulmontagekonzept vorzusehen, in welchem alle Zellen eines Moduls in einem einzigen Schritt eingekapselt und elektrisch verbunden werden. Dazu sollen die Zellen rückseitig kontaktiert werden, wobei eine Modulrückseitenebene sowohl den elektrischen Schaltkreis als auch das Einkapselmaterial in einem einzigen Stück umfaßt; und ein Einzelschrittverfahren zur Anordnung dieser Komponenten zu einem Modul vorgesehen wird. Dazu werden die rückseitig kontaktierten Zellen auf eine flächige Unterlage mit vorgeformtem elektrischen Anschlußmuster aufgelegt und über diese hinaus auf die Rückseitenebene aufgebracht. Dies erfordert die Handhabung einzelner Zellen, was bei den vorerwähnten Anwendungen wegen der Zellgröße problematisch ist.

Aus dem Aufsatz "An industrial multi-crystalline ewt solar cell with screen printed metallization" von A. Schönecker et al., 14th European Photovoltaic Solar Energy Conference, Barcelona, 1997, Seiten 796 ff. ist es bekannt, eine Vielzahl von Zellen zu verbinden, indem diese über Stromsammelschienen kontaktiert werden, beispielsweise in der vorbeschriebenen Emitter-Wrap-Through-Technologie, und dann die Stromsammelschienen der einzelnen Module durch elektrische Leiter miteinander verbunden werden. Es wird nicht angegeben, wie die einzelnen Module handzuhaben sind.

Aus dem Aufsatz "Advances in thin film PV-technologies" von H. A. Aulich, 13th European Photovoltaic Solar Energy Conference, Nizza, Frankreich, 23. bis 27. Oktober 1995, Seite 1441 ff., ist eine Vielzahl unterschiedlicher Dünnfilmsolarmodule bekannt, die überwiegend aus anderen Materialien außer Silicum bestehen. Weiter wird die Verwendung amorphen Silicums beschrieben, wobei auf sogenannte Fotodegradation hingewiesen wird, also eine Verschlechterung des Wirkungsgrades mit der Zeit.

Eine weitere Kontaktierungsmethode ist bekannt aus dem Aufsatz "High-efficiency (19,2 %) silicon thin-film solar cells with interdigitated emitter and base front-contacts" von C. Hebling et al., 14th European Photovoltaic Solar Energy Conference, Barcelona, Spanien, 30. Juni bis 4. Juli 1997. Es wird eine sogenannte SOI-Struktur, d.h. eine "Silicon on insulator Struktur" vorgeschlagen, bei welcher die eigentliche Zelle auf einer isolierenden Schicht aufgebracht wird. Das beschriebene Verfahren ist jedoch vergleichsweise aufwendig.

Aus dem Buch "Silicon solar cells - Advanced principles and practice" von Martin A. Green, ISBN 0 7334 09946, veröffentlicht vom Center for photovoltaic devices and systems, University of New South Wales, Sydney, NSW 2052 im März 1995 sind Solarzellen mit sogenannter vergrabener Struktur bekannt, in welcher Furchen in das Material mittels eines Lasers, mechanischer Schneideräder oder anderer mechanischer oder chemischer Ansätze eingebracht und die Furchen chemisch gereinigt werden; dann wird eine starke Dotierung eingebracht und die Furchen werden mit Metall aufgefüllt. Nach weiteren Schritten werden damit Kontakte erhalten. Weiter sind in dem Buch die schon vorerwähnten fingerartig rückseitenkontaktierten Zellen erwähnt sowie punktkontaktierte Solarzellen, bei welchen anstelle einer p-leitenden Stromsammelschiene p-leitendende Kontaktpunkte auf der Zelle verteilt sind, um so bestimmte Eigenschaften der Zelle besser bestimmen zu können.

Aus US-PS 4,612,408 ist ein zusammengeschaltetes SolarzellenArray bekannt, welches hergestellt wird, indem auf einer Halbleiter-Oberfläche eine Vielzahl der Vorrichtungen gebildet werden, Furchen in Oberfläche gebildet werden, die sich teilweise in das Substrat erstrecken, eine Oxidschicht auf ausgewählten Teilen der einen Oberfläche und auf den Oberflächen der Furchen gebildet wird, die Furchen mit einem isolierenden Material gefüllt werden, Metallverbindungen zwischen angrenzenden Bauelementen gebildet werden, die sich über die Furchen und das isolierende Material erstrecken, an der einen Oberfläche ein isolierender Träger angebracht wird und dann durch den Wafer hindurch in die Furchen hinein von der anderen Oberflächenseite her eine Abtrennung wird, um die angrenzenden Vorrichtungen zu trennen, während die Metallverbindungen belassen werden. Eine solche Trennung ist problematisch.

Aus der US-PS 4,300,680 ist eine Reihe streifenförmiger Halbleiterverbindungen bekannt, die auf jeweils einer der zwei Oberflächen als Halbeitersubstrates mit hohem ohmschen Widerstand angeordnet sind, wobei diese Verbindungen p+ und n+-Leitcharakteristiken im Wechsel aufweisen und parallel zueinander liegen und in Intervallen beabstandet sind, und zwar auf eine derartige Weise, daß eine Halbleiterverbindung mit einer p+-Leitfähigkeitscharakteristik auf einer Oberfläche des Halbleitersubstrates auf jeden Fall gegenüberliegend einer Halbleiterverbindung mit einer n+-Leitungscharakteristik auf der anderen Oberfläche gegenüberliegt, und gedruckte Leiterbahnen im Wechsel auf der einen und der anderen Oberfläche des Halbleitersubstrates angeordnet sind, wobei diese Bahnen in jedem Fall eine Reihen von Solarzellenverbindungen mit einer benachbarten Reihe schalten.

Aus US-PS 5,391,326 ist ein photovoltaisches Solarzellenarray bekannt, welches ohne unterstützendes Substrat monolithisch hergestellt wird, indem ein Netzwerk von Gräben von einer Seite eines Substrates gebildet wird, um separate Zellflächen zu definieren, die Gräben mit einem isolierenden Füllstoffmaterial aufgefüllt werden, das an dem Substratmaterial haftet und ihm strukturelle Integrität verleiht, und dann von der gegenüberliegenden Seite des Substrates Gräben vorgesehen werden, um ein Luftspaltisolationsnetzwerk zwischen benachbarten Zellen vorzusehen. Reihenschaltungen zwischen benachbarten Zellen werden vorgesehen, indem die Vorderseitenoberfläche einer Zelle über das Füllmaterial mit dem Volumenhalbleiter für die nächste Zelle verbunden wird, wobei die Verbindung durch den Volumenhalbleiter selbst zu Rückelektroden jeder Zelle vorgesehen wird. Die Basis ist dabei über einen kleinen emitterfreien Bereich neben dem mit Isolationsmaterial gefüllten Graben zu kontaktieren. Diese Kontaktierung ergibt eine nur kleine Kontaktierungsfläche, was zu hohen Serienwiderständen führt. Zudem wird als Füllmaterial Polyimid verwendet, das bei der Herstellung einen beachtlichen Kostenfaktor darstellt.

Aus US-PS 5,164,019 ist ein Array aus reihenverschalteten Zellen bekannt, die in einem monolithischen Halbleitersubstrat gebildet sind und elektrisch voneinander isoliert sind, indem partiell durch das Substrat gehende Furchen in einer ersten Oberfläche zwischen Zellen gebildet sind und dann das Substrat vom Boden der Furchen zu einer gegenüberliegenden Hauptoberfläche gebrochen werden. Eine Metallisierung, die die Zellen miteinander verbindet, sorgt für physikalische Integrität des Zellfeldes nach dem Brechen des Substrates. Die Furchen können vor Abschluß der Herstellung der Zellen oder nach Herstellung der Zellen gebildet werden. Problematisch ist, daß das Brechen der Zellen definiert erfolgen muß und die mechanische Stabilität ausschließlich durch typischerweise dünne Metallkontakte gewährleistet werden muß.

Aus der US-PS 5,024,953 ist ein optoelektrisch übertragendes Element und ein Verfahren zur Herstellung desselben unter Verwendung eines geriffelten Halbleitersubtrates bekannt, um ein optoelektronisch übertragenes Element zu erzeugen. Das Element hat eine verringerte effektive Dicke und eine verbesserte optoelekronische Umwandlungseffizienz, während die mechanische Stärke desselben erhalten bleibt. Dazu wird eine Form vorgesehen, die zick-zack-förmig oder im Profil mäanderförmige sein kann, wobei diese gewellten bzw. geriffelten Strukturen durchgängig sind.

Aus der DE 44 263 47 ist ein flaches Bauelement mit einem Gitternetz von Durchgangslöchern bekannt, wobei die Durchgangslöcher dadurch entstehen, daß auf der Vorder- und Rückseite eines scheibenförmigen Rundkörpers je eine Anzahl, vorzugsweise äquidistanter, paralleler, insbesondere v-förmiger Gräben eingearbeitet sind, wobei die Gräben der beiden Seiten relativ zueinander einen Winkel einschließen und jeweils so tief sind, daß an den Kreuzungspunkten der Gräben Durchgangslöcher entstehen. Die DE 44 263 47 befaßt sich dabei primär mit der Frage, wie derartige Gitternetze hergestellt werden können. Es wird vorgeschlagen, als Ausgleichsmaterial beispielsweise monokristalline Siliziumscheibenwafer gesägt aus gegossenen Siliziumblöcken, multikristalline Silizium-Bänder hergestellt durch Abscheiden aus einer Siliziumschmelze auf ein Graphitnetz usw. zu verwenden. In dem vorbekannten Dokument wird die Kontaktierung der dortigen Solarzelle erörtert, aber kein Hinweis darauf gegeben, wie sich die abgegriffene Spannung durch Zusammenschaltung mehrerer Solarzellen leicht erhöhen läßt.

Aus der US-PS 3,330,700 ist ein Solarzellenpanel bekannt mit einer Basisstruktur, die ein Metallsubstrat umfaßt, eine Isolationsschicht über dem Substrat und eine Schicht aus haftendem Material über der isolierenden Schicht, wobei ein Feld aus vier Solarzellenreihen parallel zueinander auf der Schicht aus Haftmaterial angeordnet ist und die Zellen so angeordnet sind, daß die p-Schichten einer Zellenreihe den n-Schichten der nächsten Zellenreihe benachbart sind. Die Zellen sind vereinzelt und vollständig voneinander getrennt und werden über Metallstreifen miteinander verbunden.

Aus der US-PS 3,903,427 wird ein Verbindungs- bzw. Kontaktierungsverfahren vorgeschlagen, um Leistungsverluste in der Solarzelle zu verringern. Dazu soll eine Solarzelle aus einem Halbleiterwafer gebildet werden, wobei das lichtempfindliche Halbleitermaterial eine obere und untere Oberfläche aufweist. Durch den Halbleiterwafer ziehen sich Löcher von oben nach unten, mit welchen ein elektrischer Kontakt von der Oberseite zur Unterseite hergestellt wird, wobei der von der Oberseite heruntergeführte Kontakt elektrisch gegen den Unterseitenkontakt isoliert ist, um so eine Stromabnahme zu ermöglichen. Es wird aber nicht angegeben, wie sich eine besonders günstige Reihenschaltung besonders günstig bewerkstelligen läßt.

Aus der US-PS 3,411,952 ist eine weitere Solarzellenanordnung bekannt, bei welcher eine Vielzahl von Solarzellen auf Metallstreifen angeordnet werden und mit diesen verlötet werden. Durch entsprechende Wahl der Länge und Breite jener Metallstreifen, auf welchen die einzelnen Solarzellenmodule zu liegen kommen, wird gemäß der US-PS 3,411,952 eine gewünschte Spannung erzeugt.

Aus der US-PS 4,129,458 ist eine Solarzellenanordnung bekannt, die aus mehrere beabstandeten länglichen Einheitszellen eines Feldes aus einem einzigen Wafer besteht, der längs gefurcht ist und aus einem Substratmaterial eines ersten Leitungstypes besteht, und zwar mit benachbarten Seitenwänden von benachbarten Einheiten bei jeder zwischen Einheiten gebildeten Furche. In der Querfolge derartiger Furchenbildungen sind die Seitenwände jeder zweiten Furche mit Bereichen eines zweiten Leitungstypus gebildet, so daß es bei oder nahe der der Strahlung ausgesetzten Oberfläche jeder Einheit nur eine Verbindung zwischen ersten und zweiten Leitfähigkeitstypen gibt. In einer allgemeinen Form ziehen sich die Furchen den gesamten Weg zwischen den oberen und unteren Waferoberflächen entlang, wobei sie diskrete Einzelleinheiten bilden. In einer anderen allgemeinen Form endet jede zweite Furche nahe, aber vor der oberen Oberfläche, um so diskrete Doppelzelleneinheiten zu definieren. Die Einheiten werden in Reihe geschaltet, indem ohmsche Verbindungen zwischen dem Bereich des zweiten Leitfähigkeitstypus einer Einheit und dem Bereich des ersten Leitfähigkeitstypus einer benachbarten Einheit hergestellt wird. Dies soll zu einer vergleichsweise einfachen und ökonomischen Herstellung führen. Mit dieser Zellanordnung soll erreicht werden, aus einem einzigen Substramaterialstück ein verbessertes Solarzellenfeld aufzubauen, worin die individuellen Einheiten des Feldes in präzise der gleichen positionellen Beziehung wie in dem einzelnen Ausgangsstück bleiben. Die Furchen oder Lükken zwischen den Einheiten können dabei gemäß US-PS 4,129,458 mit Isolationsmaterial gefüllt werden, oder sie bleiben partiell oder vollständig offen, wobei dann ein Träger für die relative Ausrichtung sorgen soll. Was die Furchenbildung angeht, wird lediglich vorgeschlagen, daß sich diese nicht von einer Oberfläche bis zur gegenüberliegenden vollständig hindurch erstrecken. Es können also Verbindungen bestehen bleiben, die sich über die gesamte Länge der angrenzenden Seite erstrecken.

Aus der US-PS 4,179,318, die auf dieselben Autoren wie die vorgenannte US-PS 4,129,458 zurückgeht, ist ebenfalls eine Solarzellenanordnung bekannt. Auch die dort beschriebene Furchenbildung unterscheidet sich nicht von jener der US-PS 4,129,458.

Eine weitere Anordnung einer Halbleitersolarzelle ist aus der US-PS 4,283,589 bekannt. Hier wird vorgeschlagen, zur Erhöhung der Effizienz einer Solarzelle in einem Substratkörper eine Vielzahl von lateral beabstandeten länglichen Furchen mit entgegengesetzt geneigten Seitenwänden vorzusehen, welche auf bestimmte Weise divergieren. Dabei werden die Furchen im Halbleitersubstrat auch vorgesehen, um eine bestimmte Solarzellenfeldbeschaltung zu ermöglichen. In einem in der US-PS 4,283,589 gezeigten Ausführungsbeispiel werden Zelleinheiten aus einem einzigen Ausgangssubstrat gebildet werden, in welchem Furchen vorgesehen werden, durch welche benachbarte Zelleinheiten um eine vorgegebene Breite beabstandet werden. Die Furchen erstrecken sich vollständig durch den Halbleiterwafer hindurch und eine mechanische Integrität wird entweder durch Füllung der Furchen mit geeignetem Material oder durch eine stützende Oxidschicht vorgesehen, die unterhalb der Furche verläuft.

Aus der US-PS 4,352,948 ist eine weitere Solarzelle bekannt, in welcher Furchen vorgesehen werden. Hier wird unter anderem vorgeschlagen, daß die Furchen, die in einen einzelnen Wafer eingebracht werden, die gleiche Länge aufweisen und kurz vor den gegenüberliegenden Seiten enden. Die einzelnen Furchen erstrecken sich jedoch nicht durch das Material über die vollständige Tiefe hindurch.

Aus der US-PS 4,376,872 ist eine Solarzelle bekannt, die eine Vielzahl diskreter spannungserzeugender Bereiche umfaßt, die aus einem einzigen Halbleiterwafer gebildet sind und derart zusammengeschaltet sind, daß sich die Spannungen der Einzelzellen addieren. Die Einheitszellen umfassen dotierte Bereiche entgegengesetzter Leitfähigkeitstypen, die durch eine Lücke getrennt sind. Hergestellt werden diese bekannten Solarzellen, indem v-förmige Furchen in dem Wafer gebildet werden und danach der Wafer so ausgerichtet wird, daß Ionen eines Leitfähigkeitstypus auf einer Seite der Furche implantiert werden können, während die andere Seite abgeschirmt ist. Eine Metallisierungsschicht wird aufgebracht und selektiv weggeätzt, um Verbindungen zwischen den Einheitszellen vorzusehen.

Aus der US-PS 5,067,985 ist eine Solarzelle bekannt, welche einen anisotrop geätzten, in bestimmter Weise orientierten Siliziumkristallwafer verwendet. Der Solarzellenaufbau umfaßt obere Ränder zwischen Zellkanalwänden, um die Lichteinfangsfähigkeit zu verbessern. Die Schrift befaßt sich jedoch nicht mit der Frage, wie Solarzelleinheiten aus einem einzelnen Wafer so gebildet und geschaltet werden können, daß sich eine höhere Spannung ergibt.

Aus der US-PS 5,641,362 ist eine weitere Solarzellenanordnung bekannt, welche ein bestimmtes Kontaktierungssystem verwendet, um eine preisgünstige Solarzellenanordnung vorzusehen. Dabei werden auf der Solarzellenrückseite zwei Kontaktmuster aus jeweils parallelen Streifen, die an einem Ende zu einer Stromsammelschiene verbunden sind. Der Wafer ist dabei aber bis auf allenfalls oberflächliche Änderungen durchgängig.

Aus der DE 35 29 341 A1 ist ein Solarzellenmodul bekannt, welches mehrere, auf einem Trägerkörper angeordnete und miteinander elektrisch leitend verbundene Einzelzellen aufweist, wobei der Trägerkörper flächengleich ist mit den Einzelzellen einschließlich den zwischen ihnen verlaufenden Trennschlitzen.
Die Rückseitenkontakte der Solarzellen werden durch Kontaktierungen im Trägerkörper mit zugeordneten Anschlußkontaktflächen auf der Rückseite des Trägerkörpers elektrisch leitend verbunden. Als Trägerkörper kann beispielsweise ein glasfaserverstärkter Kunststoff mit einer Dicke von 0,3 mm verwendet werden. Auf den Trägerkörper wird eine Anschlußkontaktierung aufgebracht und mit dieser eine großflächige Solarzelle verlötet, die flächengleich ist mit der Gesamteinheit des Trägerkörpers. Dann wird die auf dem Trägerkörper angebrachte Halbleiterscheibe durch Trennschnitte unterteilt, so daß die Notwendigkeit entfällt, jede Einzelzelle gesondert handzuhaben. Die Verwendung und aufwendige Gestaltung des Trägerkörpers sind jedoch unerwünscht, da sie kostenintensiv sind.

Aus der WO 89/05521 ist eine Solarzellenanordnung aus einer Vielzahl zusammengeschalteter Solarzellmatrizen bekannt. Jede Matrix umfaßt eine Vielzahl von reihengeschalteter Solarzellen des Emitter-Wrap-Through-Typus. Mit dieser Anordnung soll eine Beschädigung der Solarzelle insbesondere bei Raumfahrtanwendungen vermieden werden. Es wird vorgeschlagen, jede Solarzellenmatrix aus einem einzigen Wafer herzustellen, auf dem ein pn-Übergang und eine Anzahl von Vorder- und Rückseitenkontakten gebildet werden, bevor der Wafer auf ein Abdeckglas gelegt wird und in eine Vielzahl individueller Solarzellen aufgeteilt wird. Nachteilig ist hier wiederum die erforderliche Verwendung eines Abdeckglases.

Aus der älteren WO 98/54763 ist eine Solarzelle in einem Halbleitersubstrat bekannt, bei welcher eine bestimmte Art der Kontaktierung vorgeschrieben wird, ohne daß vorgeschlagen wird, einen größeren Halbleiter in eine Vielzahl von Einzelbereichen aufzuteilen.

Das Ziel der vorliegenden Erfindung besteht gegenüber dem vordiskutierten Stand der Technik darin, eine neue Solarzellenanordnung für die gewerbliche Anwendung bereitzustellen, um eine reihenverschaltete Solarzelle zu erhalten, die eine kostengünstige Fertigung ermöglicht.

Die unabhängigen Ansprüche geben an, wie das Ziel der vorliegenden Erfindung zu erreichen ist; bevorzugte Ausführungsformen finden sich in den abhängigen Ansprüchen.

Ein erster Grundgedanke der Erfindung besteht somit darin, eine Solarzellenanordung aus serienverschalteten Solar-Unterzellen vorzusehen, die aus einem Halbleiterwafer-Grundmaterial gebildet sind, in welchem eine Vielzahl von Ausnehmungen zur Abgrenzung der einzelnen, in Serie verschalteten Solar-Unterzellen vorgesehen sind, wobei sich zumindest einige der Ausnehmungen von der Oberseite der Solarzellenanordnung bis zu deren Unterseite durch die Solarzellenanordnung hindurch erstrecken und in Fortsetzung der Ausnehmungen zur seitlichen Solarzellenanordnungskante hin an dieser Brückenstege belassen sind, um über diese die Solar-Unterzellen mechanisch miteinander zu verbinden.

Durch diese Brückenstege wird erreicht, daß die jeweiligen Solar-Unterzellen elektrisch hinreichend voneinander getrennt werden, aber dennoch ein mechanischer Zusammenhalt gegeben ist, der es ermöglicht, die Solarzellenanordnung wie ein einzelnes Materialstück handzuhaben. Das Verwenden von einigen wenigen Brückenstegen ermöglicht dabei eine wesentlich bessere Isolation der Unterzellen bei einer wesentlich besseren Stabilität. "Quasi-Kurzschlüsse" entstehen nur lokal und sind nicht über die gesamte Unterzellenlänge verteilt. Die Brückenstege erübrigen dabei auch auf einfache Weise die Verwendung teuren Füllmaterials wie Polyimid und können so schmal gebildet werden, daß die elektrischen Eigenschaften der Solarzellenanordnung allenfalls minimal beeinträchtigt wird. Es wird also vorgesehen, daß ein kristalliner Halbleiter-Wafer - vorzugsweise aus Silizium - zur Herstellung sämtlicher Zellen der Solarzellenarodnung verwendet wird, wobei die elektrische Isolation der Unterzellen durch partielles Ausdünnen des Wafers erfolgt.

Das partielle Ausdünnen ist so geartet, daß das Halbleitermaterial zwischen zwei Unterzellen bis auf die verbleibenden Brückenstege vollständig entfernt wird und somit schmale langgezogene Löcher bzw. Schlitze in den Wafer eingebracht werden.

Wenn auf einer Seite der Solar-Unterzellen je ein Fingergrid für Emitter und Basis vorgesehen ist, wird es bevorzugt, daß am Fingergrid für Emitter und Basis eine Stromsammelschiene vorgesehen ist, die derart angeordnet ist, daß zwei benachbarte Solar-Unterzellen über eine gemeinsame Stromsammelschiene elektrisch miteinander verbunden sind. Diese Stromsammelschiene kann auf den Brückenstegen verlaufen.

Im Bereich der Brückenstege kann auf dem Halbleitermaterial des Wafers ein damit fest verbundenes isolierendes Material, insbesondere eine Oxidschicht vorgesehen sein, wobei über dieser Isolatorschicht eine Leiterbahn vorgesehen ist.

Die Solarzellenanordung kann Solar-Unterzellen mit wenigstens zwei unterschiedlichen Flächen aufweisen, wobei sich insbesondere die am Rand angeordneten Unterzellen in der Fläche von den mittleren Unterzellen unterscheiden. Eine solche Ausbildung hat eine Wirkungsgraderhöhung der Gesamtanordnung zur Folge. Dies wird zurückgeführt auf eine unvollständige Isolation der Unterzellen untereinander, die eine physikalische Unsymmetrie bedingt. Diese Unsymmetrie hat wiederum zur Folge, daß die einzelnen Unterzellen an verschiedenen Arbeitspunkten betrieben werden, was bedeutet, daß im Gegensatz zu herkömmlichen Modulen, bei denen die Größe der einzelnen Zellen möglichst gleich zu halten ist, eine Variation in den Größen der einzelnen Unterzellen Wirkungsgrad steigernd sein kann. Es kann gezeigt werden, daß die am Rand liegende und den Minuspol der Solarzellenanordnung darstellende Zelle in ihrer Fläche gegenüber den restlichen Unterzellen zu verkleinern ist. Wie groß die Flächenverhältnisse zu wählen sind, hängt von der Güte der Isolierung zwischen den Unterzellen sowie der gewählten Solarzellenanordnungsgeometrie ab. Je besser die Isolierung, desto weniger sollten sich die Unterzellenflächen unterscheiden. Gemäß einer bevorzugten Ausführungsform des Verfahrens der vorliegenden Erfindung wird

In einer besonders bevorzugten Ausführungsform der Solarzellenanordung sind die Brückenstege zum Kontakt mit einer externen Bauteileinheit ausgebildet. vor dem Zersägen des Halbleiterwafer-Grundmaterials ein Kontaktelement seitlich angebracht. Dies ermöglicht es, in konsequentester Weise das Halbeiterwafer-Grundmaterial komplett zu durchtrennen und die Brückenstege extern durch eine seitlich aufzubringende Verschaltungsleiste als externe Bauteileinheit anzubringen.

Es wird überdies angegeben, wie die Solarzellenanordung aus serienverschalteten Solar-Unterzellen gebildet werden kann, nämlich dadurch, daß die Ausnehmungen mittels einer Wafersäge, unter Verwendung eines Laser, durch Drahtsägen, Ätztechniken, Sandstrahlern, Wasserstrahlern, Ultraschallbehandlung oder eine Kombination dieser Techniken erzeugt werden.

Hierbei können die Ausnehmungen insbesondere mittels einer Wafersäge erzeugt werden, indem diese stufenweise auf den Wafer abgesenkt und über diesen hinweg bewegt wird wobei die Wafersäge bevorzugt an einer ersten Stelle auf das Wafer-Grundmaterial abgesenkt wird, über das Wafer-Grundmaterial bis zu dem Beginn des Brückensteges bewegt wird, mit einer gegebenen Absenkung über das Wafer-Grundmaterial wenigstens einmal entlang der Furche hinweg bewegt wird, und danach weiter abgesenkt und erneut bewegt wird. Auf diese Weise lassen sich die Brückenstege ohne weiters ausbilden, ohne daß die Gefahr eines Bruches wesentlich ist. Es kann auch vorgesehen werden, daß eine Wafersäge unter vorzugsweise schneller Drehung gesteuert und/oder geregelt auf den Wafer abgesenkt, durch das Wafer-Grundmaterial hindurch und dann quer über das Wafer-Grundmaterial hinweg bewegt wird.

Wenn die Solarzellenanordung aus serienverschalteten Solar-Unterzellen mit einer Kontaktleiste an der seitlichen Solarzellenanordnungskante versehen wird, können die Brückenstege von dieser Kontaktleiste umgriffen sein. An der Kontaktleiste können Metallbügel vorgesehen sein, welche die eine elektrische Verbindung von jeweils einem Unterzellenrückkontakt zum Frontkontakt einer weiteren Unterzelle schaffen und so eine Serienverschaltung der Unterzellen gewähren, wobei sie Aussparungen enthalten, durch welche Trennwerkzeuge hindurch geführt werden können.

Eine weitere, hier nicht beanspruchte Möglichkeit, Handhabbarkeit und Isolation serienverschalteter Solar-Unterzellen zu erreichen, besteht darin, daß ein Halbleiterwafer auf einem Trägersubstrat angeordnet wird und anschließend zur Erzeugung und Isolation der Unterzellen durchgehende Schnitte erhält. Das Trägersubstrat kann für externe Beschaltung der Solar-Unterzellen gebildet sein und/oder mit Gräben versehen sein, durch welche Trennwerkzeuge zur Bildung von durch den Wafer hindurch gehenden Ausnehmungen geführt werden können, ohne das Trägersubstrat selbst zu beschädigen.

Die Erfindung wird im folgenden nur beispielsweise unter Bezug auf die Zeichnung beschrieben. In dieser zeigt/zeigen:
- Fig.1: einen Ausschnitt der Vorderseite eines Solarzellenanordnungs-Kleinstmoduls mit monolithischer Verschaltung über Einbuchtungen an der Kante
- Fig.2: einen Ausschnitt der Rückseite des Solarzellenanordnungs-Kleinstmoduls von Fig. 1;
- Fig.3: einen Ausschnitt der Rückseite eines weiteren Solarzellenanordnungs-Kleinstmoduls, wobei eine Verschaltung über Einbuchtungen an der Kante und durchgängige rückseitige Gräben vorgenommen ist;

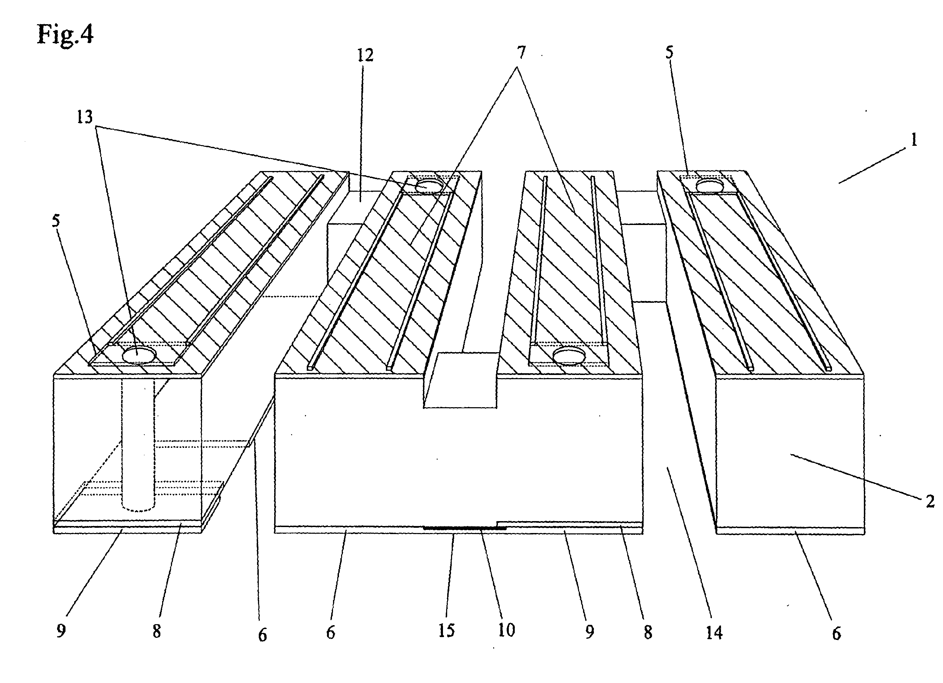

- Fig.4: einen Ausschnitt der Vorderseite eines Solarzellenanordnungs-Kleinstmoduls mit monolithischer Verschaltung über Löcher durch das Wafer-Grundmaterial, wobei zur Vereinfachung nur die Position einiger Löcher schematisch und stark vergrößert angegeben sind;

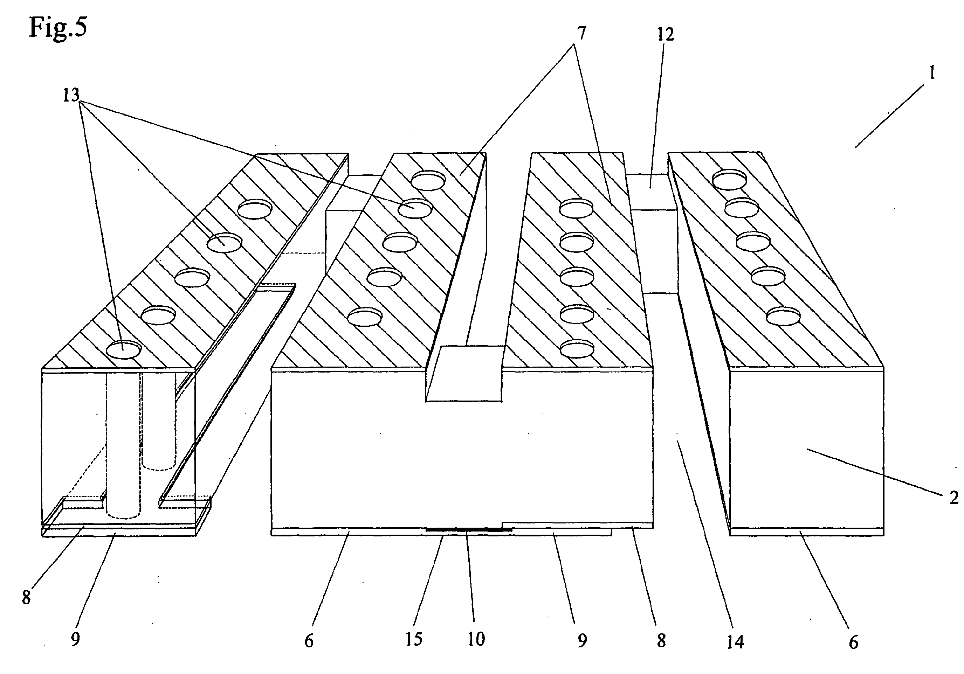

- Fig.5: einen Ausschnitt der Vorderseite eines Solarzellenanordnungs-Kleinstmoduls mit monolithischer Verschaltung über Löcher durch das Wafer-Grundmaterial nach dem Emitter-Wrap-Through-Prinzip (zur Vereinfachung ist nur die Position einiger Löcher schematisch und stark vergrößert angegeben),

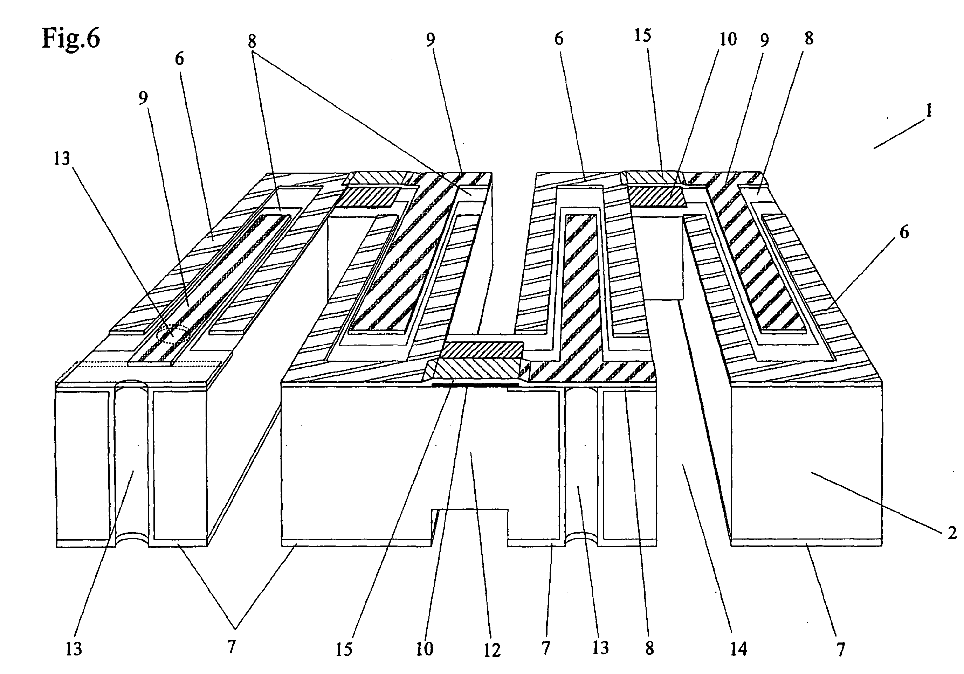

- Fig.6: einen Ausschnitt der Rückseite eines Solarzellenanordnungs-Kleinstmoduls mit monolithischer Verschaltung über Löcher durch das Wafer-Grundmaterial nach dem Emitter-Wrap-Through-Prinzip, wobei zur Vereinfachung nur die Position einiger Löcher schematisch und stark vergrößert angegeben ist;

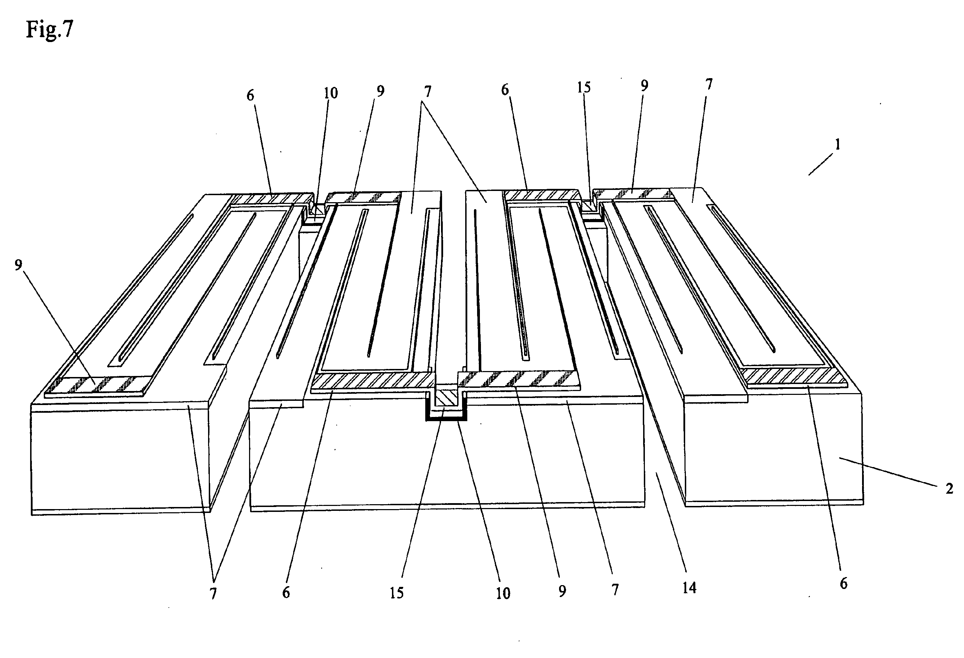

- Fig.7: einen Ausschnitt der Vorderseite eines weiteren Ausführungsbeispiels des Solarzellenanordnungs-Kleinstmoduls mit monolithischer Verschaltung durch frontseitige ineinander greifende Kontaktgrids und Isolation der Kontaktverbindung mittels einer Isolatorschicht;

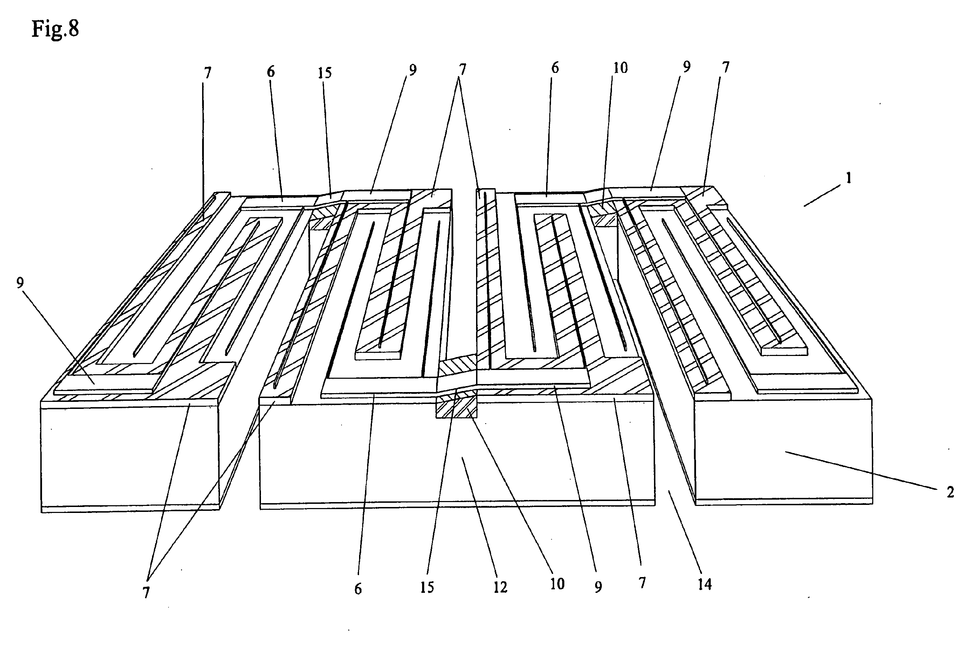

- Fig.8: einen Ausschnitt der Vorderseite eines weiteren Ausführungsbeispiels des SolarzellenanordnungsKleinstmoduls mit monolithischer Verschaltung durch frontseitige ineinander greifende Kontaktgrids und durch Planarisierungssägewalzen freigelegte Basiskontaktbereiche;

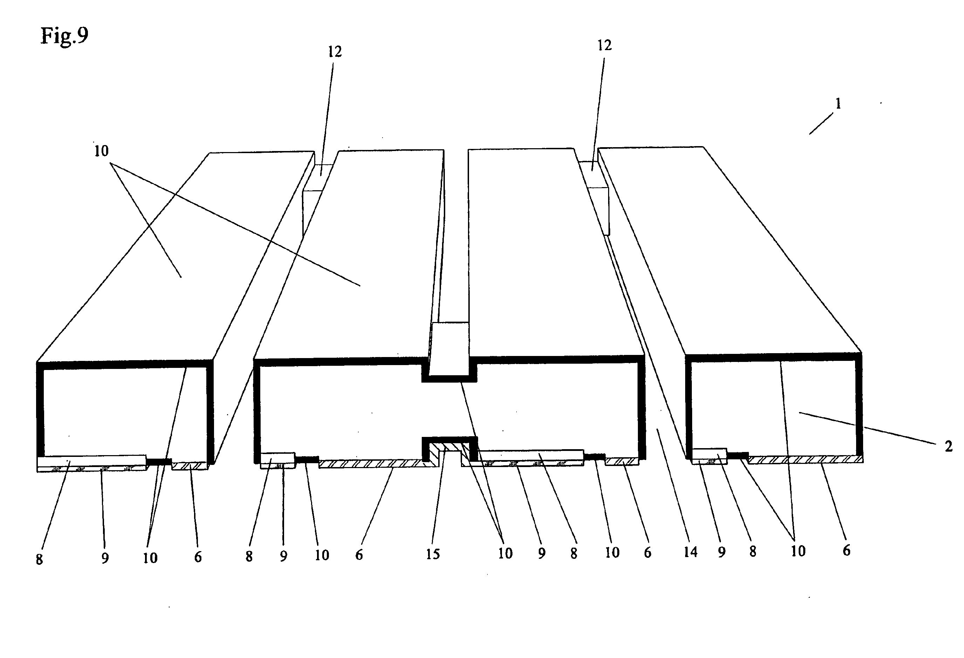

- Fig.9: einen Ausschnitt der Vorderseite eines weiteren Ausführungsbeispiels des SolarzellenanordnungsKleinstmoduls mit monolithischer Verschaltung durch rückseitige ineinander greifende Kontaktgrids nach dem "Interdigitated-Back-Contact"-Solarzellenkonzept, wobei kein frontseitiger Emitter vorhanden ist und die Unterzellen fast vollständig mit einer passivierenden Oberflächenschicht ummantelt sind;

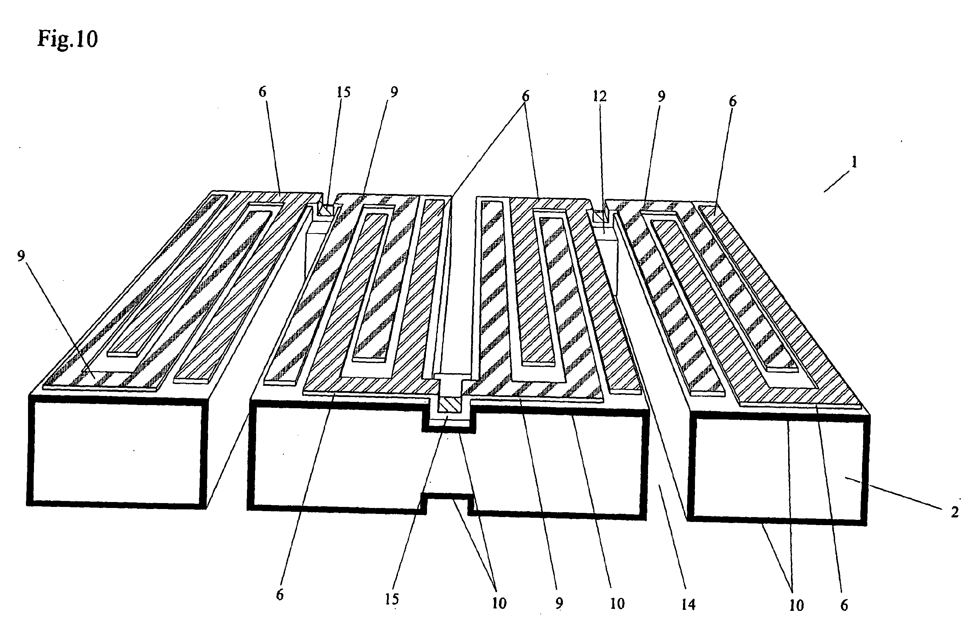

- Fig.10: einen Ausschnitt der Rückseite eines Solarzellenanordnungs-Kleinstmoduls mit monolithischer Verschaltung durch rückseitige ineinander greifende Kontaktgrids nach dem "Interdigitated-Back-Contact"-Solarzellenkonzept;
- Fig.11a)-f): verschiedene Zellgeometrien in der Draufsicht, wobei einzelne Details des Solarzellenanordnungs-Kleinstmoduls, wie Kontaktfinger und Busbars nicht eingezeichnet sind;

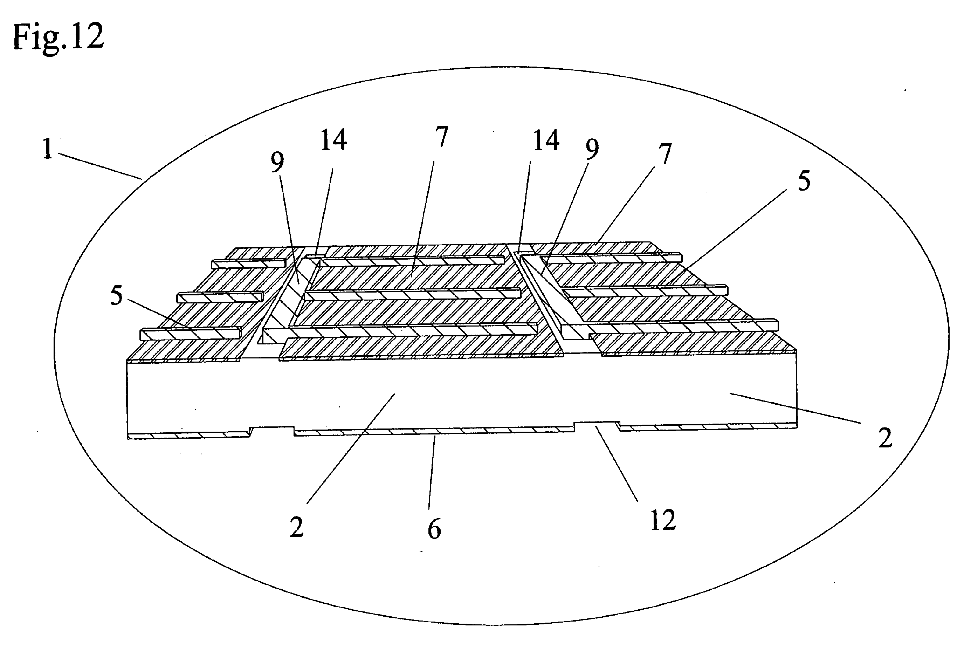

- Fig.12: einen Ausschnitt der Vorderseite eines weiteren Ausführungsbeispiels des Solarzellenanordnungs-Kleinstmoduls mit monolithischer Verschaltung über die Schnittbereiche;

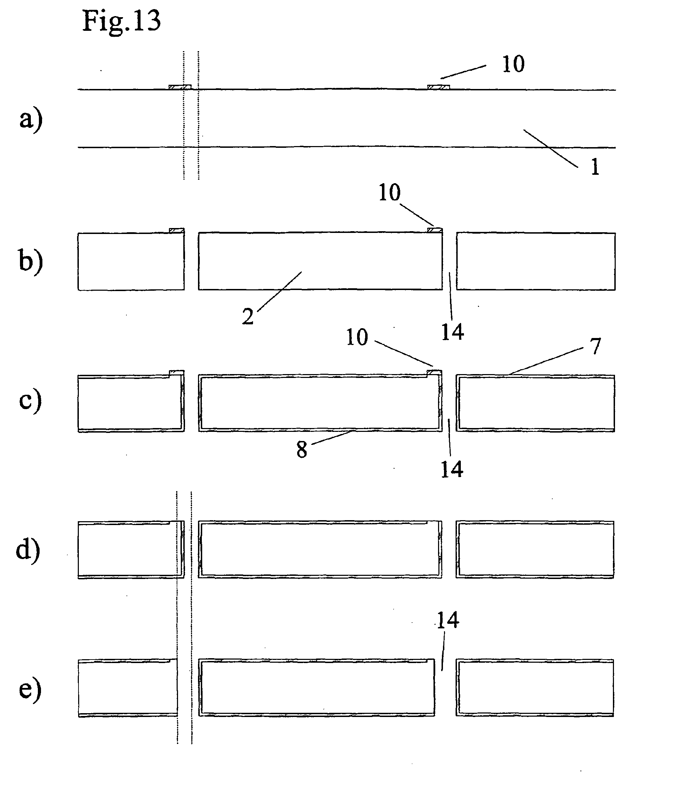

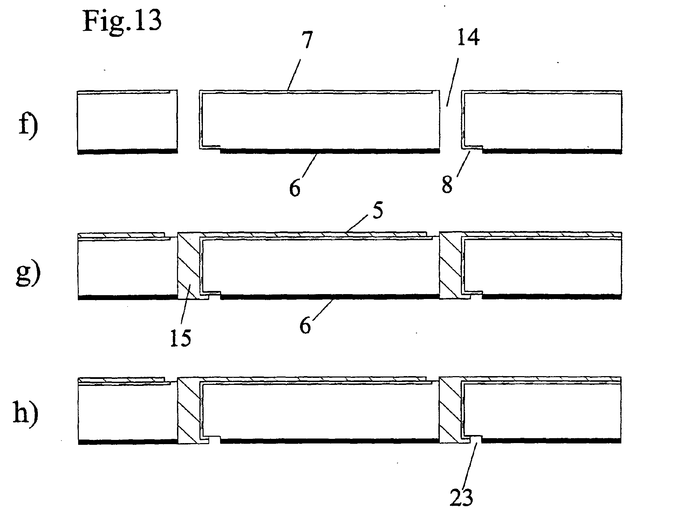

- Fig.13: eine beispielhafte Prozeßsequenz zur Herstellung eines Solarzellenanordnungs-Kleinstmoduls nach Fig.12;
- Fig.16a-j: eine beispielhafte Prozeßsequenz zur Herstellung eines Solarzellenanordnungs-Kleinstmoduls mit monolithischer Verschaltung;

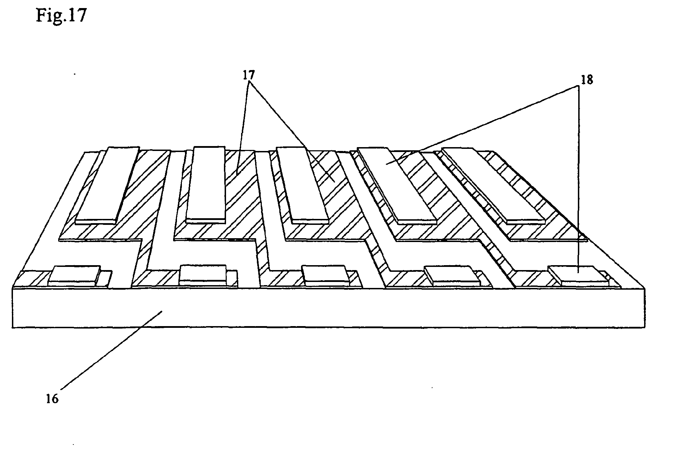

- Fig.17: eine Trägerplatine mit Leiterbahnen zur Serienverschaltung mit aufgebrachtem Lötmaterial;

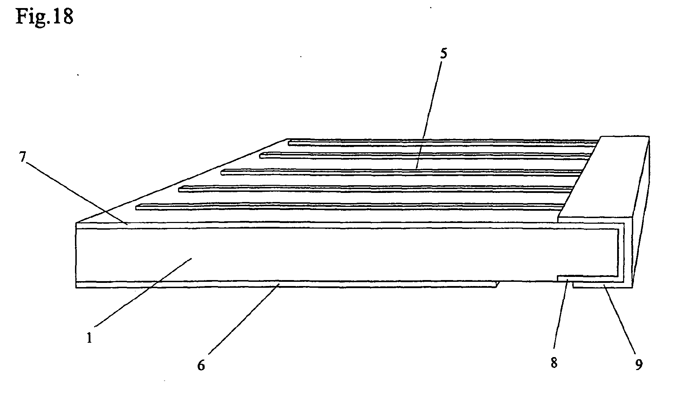

- Fig.18: eine Solarzelle mit um die Kante gezogenem Emitter und Emitterkontakt;

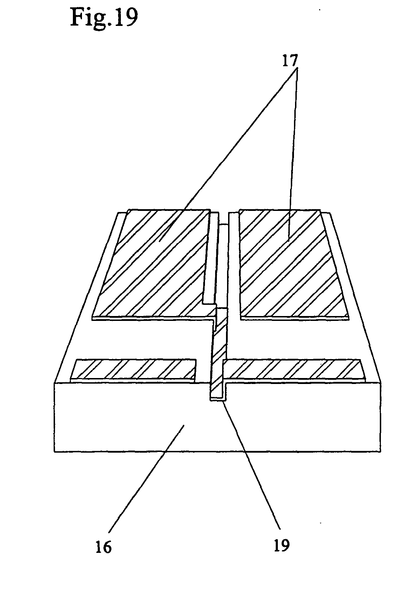

- Fig.19: einen Teil einer Trägerplatine mit Substratgraben und Leiterbahnen.

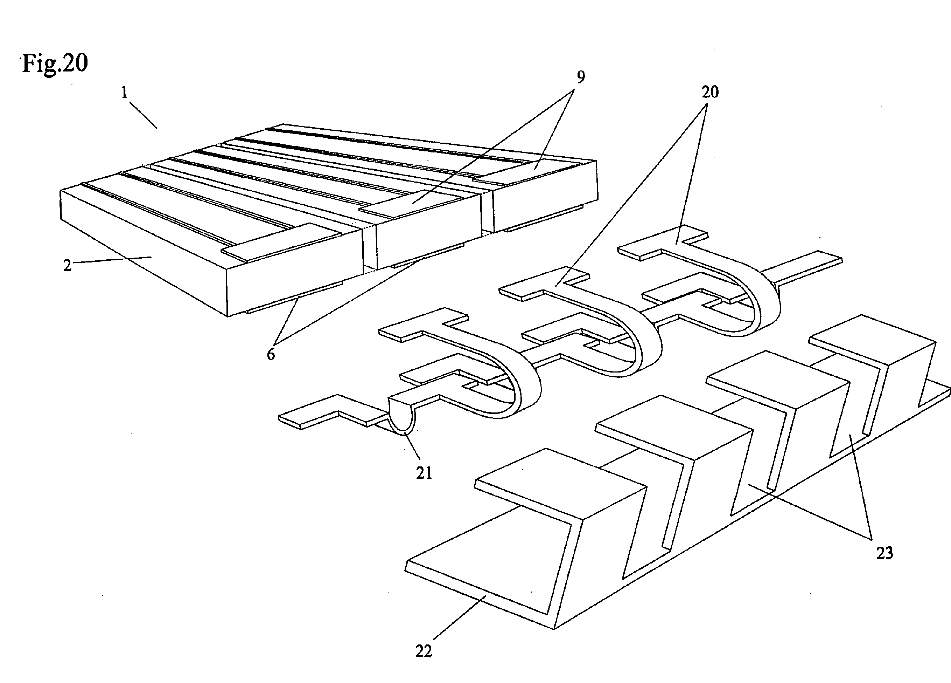

- Fig.20: mehrere Kontaktbügel, welche Bestandteile einer Kontaktleiste mit Aussparungen sind, sowie mehrere Solar-Unterzellen;

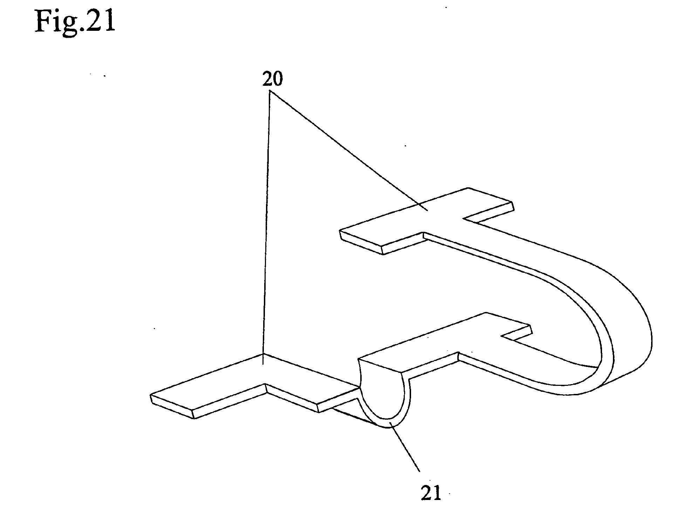

- Fig.21: die Ansicht eines einzelnen Kontaktbügels mit einer Lasche, durch welche Sägeblätter beim Trennen der Unterzellen hindurch geführt werden können.

In den Figuren bezeichnen gleiche Bezugszeichen gleiche oder ähnliche Bauelemente. Dabei wird die Bezugszahl 1 für den Wafer verwendet; es wird weiter bezeichnet eine Solar-Unterzelle mit 2, ein rückseitiger Graben mit 3, eine Einbuchtung mit 4, ein Emitterkontaktfinger mit 5, eine Basiskontaktmetallisierung als 6, ein frontseitiger Emitter als 7, ein rückseitiger Emitter als 8, eine Emitterkontaktmetallisierung als 9, ein Dielektrikum bzw. eine Isolatorschicht (Nitridschicht) als 10, ein Verbindungsbereich als 12, ein Loch als 13, ein Schnittbereich als 14, eine Kontaktverbindung als 15, ein Trägersubstrat bzw. eine (Trägerplatine) als 16, eine Leiterbahn als 17, Lötmaterial als 18, ein Substratgraben als 19, ein Kontaktbügel als 20, eine Lasche als 21, ein Leistengehäuse als 22, eine Aussparung als 23 und ätzresistenter Lack als 24.

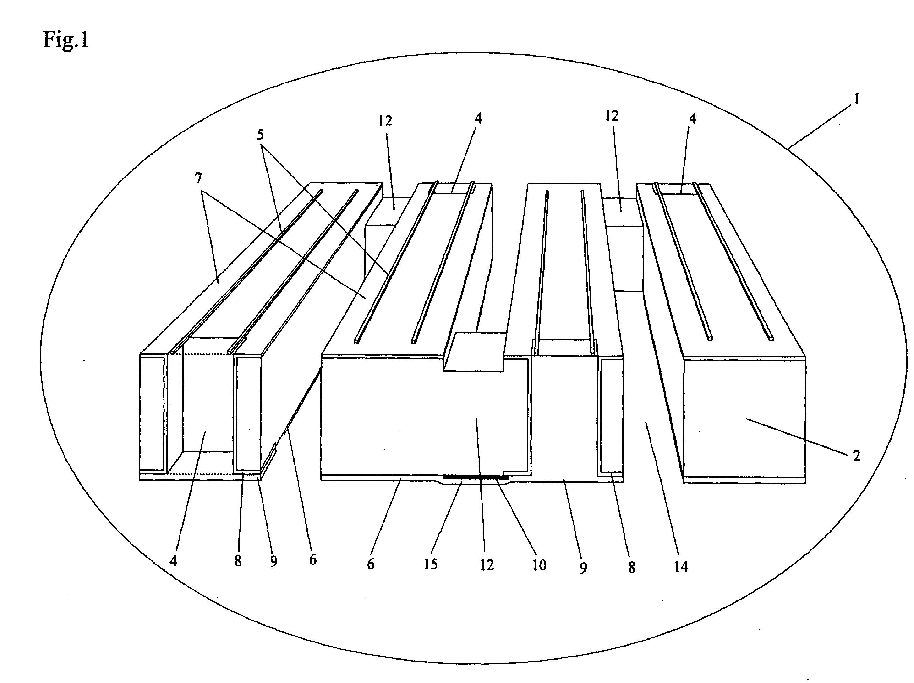

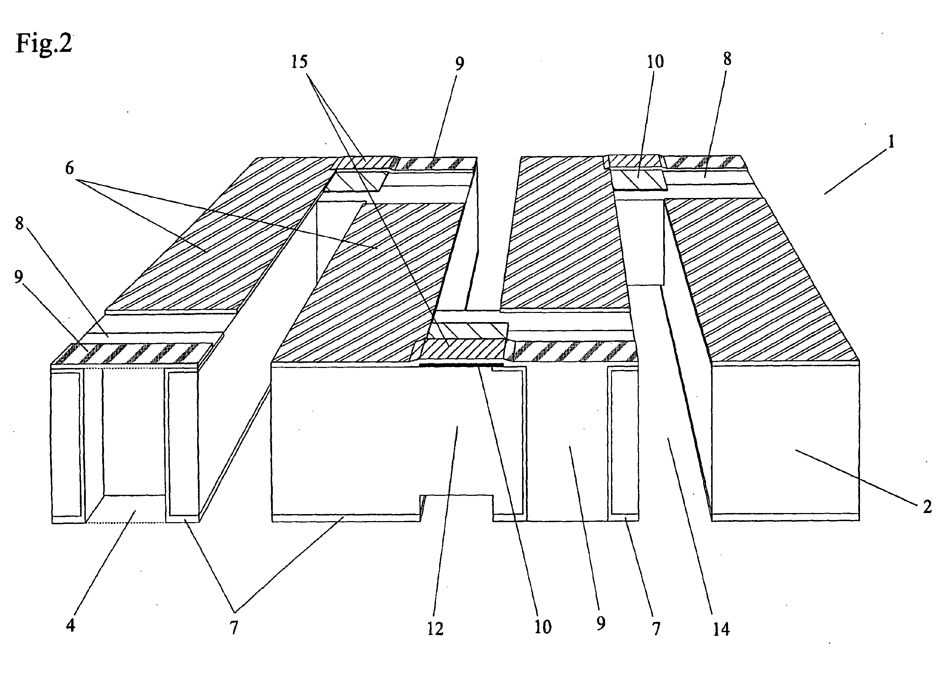

In Figur 1 und 2 ist ein erstes Ausführungsbeispiel der Erfindung gezeigt. Bei diesem sind in einen Wafer 1 von zwei gegenüberliegenden Waferkanten Schnitte **14** eingebracht, so daß ein mäanderförmiges Band von Unterzellen 2 entsteht, deren frontseitige Emitter **7** untereinander durchtrennt sind. Ein kleiner Bereich jeder Unterzellenrückseite ist mit einem Emitter (rückseitiger Emitter **8)** versehen. Der frontseitige Emitter **7** ist über, ebenfalls mit einer Emitterschicht versehene, Einbuchtungen **4** an der Waferkante mit dem rückseitigen Emitter **8** verbunden.

Sowohl die rückseitig freiliegenden Zellbasen als auch die rückseitigen Emitterbereiche **8** sind jeweils voneinander räumlich getrennt metallisiert, wobei mittels kurzer Busbars, d.h. Kontaktverbindungen **15** über die verbliebenen Verbindungsbereiche **12** hinweg eine Serienverschaltung benachbarter Unterzellen **2** vorgenommen ist, um so eine monolithischen Verschaltung der Unterzellen **2** zu ermöglichen.

Der rückseitige Busbar (Kontaktverbindung **15)** ist mittels einer Siebdruckpaste aufgebracht, wobei die Paste dabei auch die Einbuchtungen **4** am Waferrand füllt. Das die Einbuchtungen **4** ausfüllende Metall bildet eine elektrische Verbindung zwischen dem auf der Zellvorderseite aufgebrachten Emitterkontaktfinger **5** sowie der Basismetallisierung **6** der benachbarten Unterzelle und gewährleistet somit geringe Serienwiderstandsverluste.

Die Kontaktverbindung **15** verläuft über einer Isolatorschicht **10,** welche so angeordnet ist, daß sie einen Kurzschluß zwischen rückseitigem Emitter **8** einer Unterzelle und der Zellbasis derselben Unterzelle verhindert, wobei andererseits der Abstand zwischen dem rückseitigen Emitter **8** einer Unterzelle und der Basiskontaktmetallisierung **6** der benachbarten Unterzelle vergrößert ist.

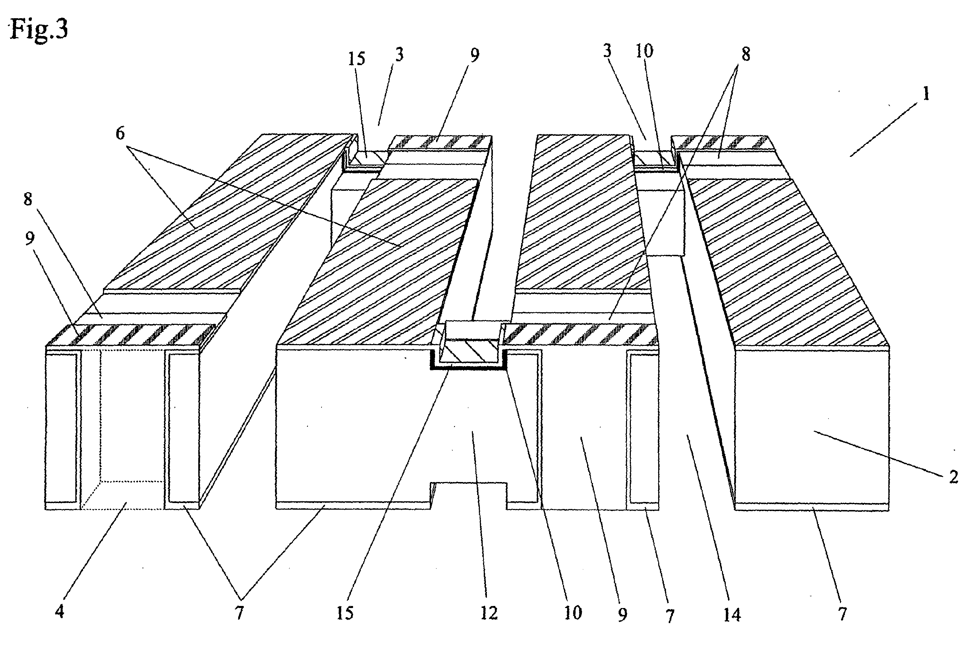

In Figur 3 ist gezeigt, daß in den Verbindungsbereich **12** optional ein rückseitiger Graben 3 eingebracht werden kann. Mit diesem wird berücksichtigt, daß Prozesse, bei denen nach der Erzeugung eines Elektron-Loch Paars das Elektron zum Emitter, das Loch aber zum Basiskontakt der benachbarten Unterzelle gelangen einen Verlustmechanismus darstellen, weshalb auch der Abstand vom Emitter zum Basiskontakt der benachbarten Unterzelle möglichst groß zu gestalten ist.

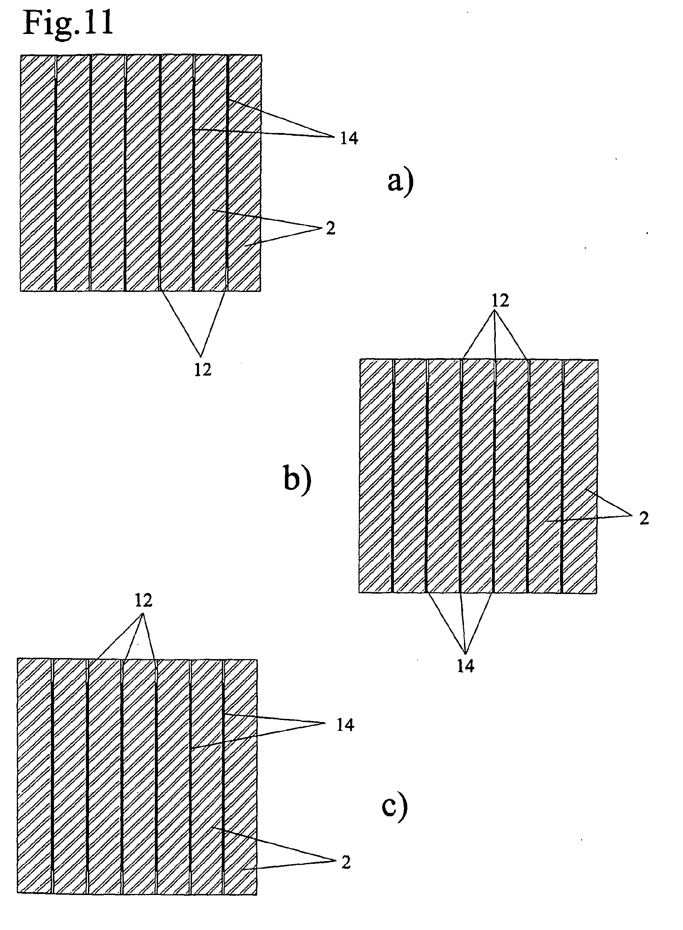

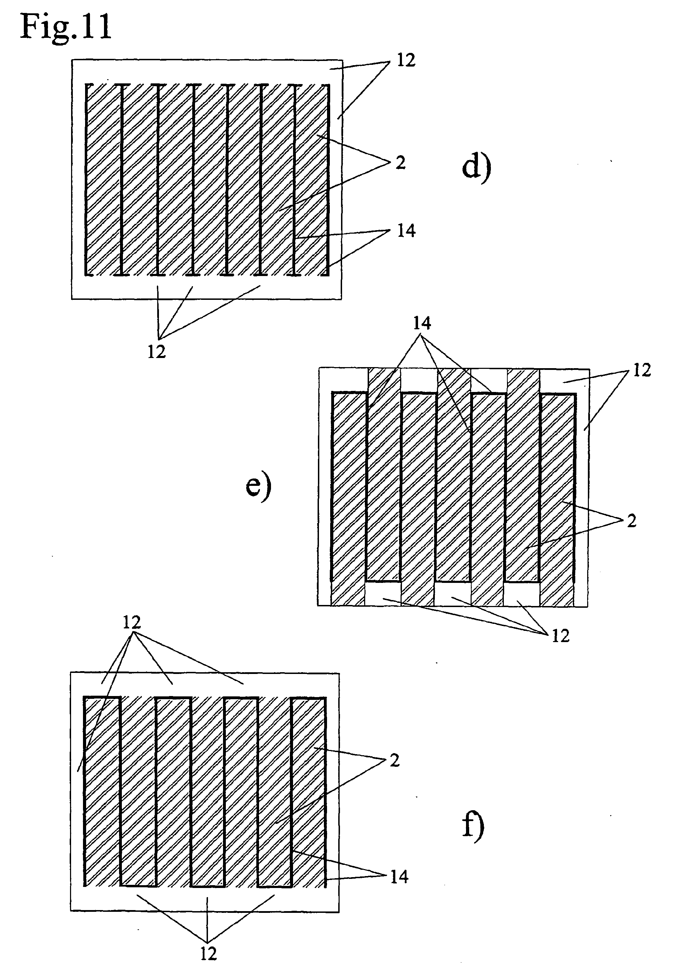

Die hier vorgestellte mäanderförmige Kleinstmodul- d.h. Solarzellenanordnungsgeometrie ist vorteilhaft, weil sie eine einfache Serienverschaltung zweier Unterzellen mittels eines gemeinsamen Busbars (Kontaktverbindung **15)** über die verbleibenden Verbindungsbereiche **12** hinweg ermöglicht. Aber auch kammförmige Geometrien oder Anordnungen mit mehreren Brückenstegen (Verbindungsbereiche **12)** zwischen zwei Unterzellen sind realisierbar. Auf die Fig. 11 wird hierzu verwiesen. Dort sind Kleinstmodulgeometrien in der Draufsicht dargestellt. Einzelne Details des Solarzellenanordnungs-Kleinstmoduls, wie Kontaktfinger und Busbars sind nicht eingezeichnet. Es stellen die dicken schwarzen Linien die durch den Wafer hindurch reichenden Schnitte **14** dar, während die schraffierten Flächen die eigentlichen Unterzellen **2** kennzeichnen. Weiße Bereiche stehen für die Brückenstege **12.** Grenzen benachbarte Brückenstege **12,** wie bei den Geometrien d) und f), direkt aneinander, so ergibt sich ein Rahmen, auf welchem die die Unterzellen verbindenden Busbars verlaufen können. Durch die Vergrößerung des Abstands zwischen Unterzellen, bzw. durch die Verlängerung der verbindenden Brückenstege **12**, besitzen die Geometrien d)-f) eine gegenüber den Geometrien a)-c) erhöhte Isolation der Unterzellen untereinander.

Eine mögliche Prozeßsequenz zur Herstellung des erfindungsgemäßen Solarzellenanordnungs-Kleinstmoduls (**Fig**.1 und 2) wird im folgenden näher erläutert.

Als Ausgangsmaterial für den Herstellungsprozeß können kristalline Siliziumscheiben dienen. Ob mono-, multi- bzw. polykristalline Wafer verwendet werden, ist abhängig von den angestrebten Wirkungsgraden und den Materialkosten. Für die prinzipielle Funktionsweise des Solarzellenanordnungs-Kleinstmoduls ist die Kristallinität des Materials von untergeordneter Bedeutung. Im folgenden wird von einem p-dotierten Wafer ausgegangen obwohl auch n-Typ Wafer vorstellbar sind.
1.Zuerst erfolgt ein polierender Defekt-Ätzschritt, bei dem eine Oberflächenschicht von ca. 10-20 µm entfernt wird, um die Oberflächenschäden, die eventuell bei der Wafertrennung aus dem Ingot entstanden, zu entfernen. Dazu kommen alkalische Lösungen (z.B. NaOH), Säurengemische und Trockenätzverfahren in Frage.
2.Darauf folgend wird eine Isolatorschicht - z.B. ein Nitrid, insbesondere eine Siliziumnitridschicht, Si₃N₄ - auf die Rückseite aufgebracht, welche als Barriere für eine spätere Emitterdiffusion dient. Entlang einer Waferkante wird bei jeder zweiten Unterzelle **2** ein Randstreifen von einigen Millimetern Tiefe und der Breite der zu entstehenden Unterzelle vor dem Nitrid geschützt. Das gleiche gilt für die gegenüberliegende Waferkante; allerdings kommen die freien Stellen um eine Unterzelle **2** versetzt zu liegen. (Die Randstreifen entsprechen den späteren rückseitigen Emittergebieten **8** in **Fig**.2). Das Schützen dieser Zellbereiche vor der Ausbildung einer Isolator- bzw. Nitridschicht kann z.B. durch Auflegen einer Maske während einer gerichteten PECVD (Plasma Enhanced Chemical Vapour Deposition) Nitridabscheidung erfolgen.
3.Im dritten Prozeßschritt wird an jeweils einer Stirnseite einer Unterzelle **2** eine Einbuchtung **4** vorgenommen, welche die Waferkante lokal weiter nach innen verlegt. Dies kann z.B. mit einer Wafersäge durch seitlich einzubringende Schnitte erfolgen. Die Einbuchtungen **4** dienen der Verbindung des zu entstehenden frontseitigen Emitters 7 mit der Zellrückseite. Sie können auch als ganz an den Zellrand verlegte, senkrecht durch den Wafer **1** reichende Löcher angesehen werden.
4.Eine anschließende Phosphordiffusion erzeugt eine n-dotierte Emitterschicht auf der Wafer-Vorderseite (frontseitiger Emitter **7),** an den Waferkanten, in den Einbuchtungen **4** und auf den vom Nitrid befreiten Teilen der Wafer-Rückseite (rückseitiger Emitter **8).**
5.Im fünften Prozeßschritt wird - z.B. mittels Siebdrucktechniken - eine ätzresistente Paste so auf die Rückseite der später zu verbleibenden Verbindungsbereiche **12** gedruckt, daß sowohl ein Teil der Nitridschicht auf dem Verbindungsbereich **12** als auch auf dem daneben liegenden rückseitigen Emitter **8** mit der Paste bedeckt ist.
6.Das Nitrid, welches nicht durch die ätzresistente Paste geschützt ist, wird in einer Flußsäurelösung (HF) entfernt.
7.Anschließend kann die ätzresistente Paste selbst wieder entfernt werden. Auf diese Weise verbleibt auf einem Teil der Verbindungsbereiche eine isolierende Nitridschicht **10,** die eine direkte Kurzschlußbildung an den Rändern der rückseitigen Emitterbereiche **8** bei der folgenden Serienverschaltung mittels Siebdruck verhindert.
8.Zur Kontaktierung der Zellbasen wird eine aluminiumhaltige Paste so auf die Zellrückseite aufgedruckt, daß jeweils der größte Teil des frei liegenden p-dotierten Materials einer Unterzelle **2,** von der Paste bedeckt ist. Beim später zu erfolgenden Feuern wird eine einheitliche Basiskontaktmetallisierung **6** mit darunterliegender p⁺⁺ Schicht ausgebildet. Die p⁺⁺ Schicht erzeugt ein sogenanntes Back Surface Field, welches eine vermehrte Diffusion von lichtgenerierten Minoritätsladungsträgern in Richtung Frontseite bzw. Emitter bewirkt.
9.Mittels einer silberhaltigen Paste werden die rückseitigen Emitterregionen kontaktiert (Emitterkontaktmetallisierung **9**), und über den mit Nitrid bedeckten Teil der Verbindungsbereiche **12** mit der Basiskontaktmetallisierung **6** der jeweils benachbarten Unterzelle verschaltet. Die Paste wird dabei auch durch die Einbuchtungen **4** bis an die Zellvorderseite gedrückt.
10.In einem letzten Siebdruckschritt können auf der Zellvorderseite ebenfalls mit einer silberhaltigen Paste schmale Metallisierungsfinger (Emitterkontaktfinger **5**) aufgedruckt werden, welche via den Einbuchtungen **4** mit der rückseitigen Emittermetallisierung **9** verbunden sind. Darauf folgt das Kontaktfeuern.
11.Im elften Prozeßschritt werden einige Micrometer Silizium entlang jeder Waferkante entfernt, um die Emitterschicht an den Waferkanten und die daraus resultierenden Kurzschlüsse der Unterzellen zu beseitigen. Damit stellen die Einbuchtungen **4** die einzigen Verbindungen des frontseitigen Emitters **7** mit den Emitterregionen der Zellrückseite **8** dar.
   Gleichzeitig kann das Silizium zwischen den Unterzellen **2** bis auf die Bereiche der Kontaktverbindungen **15** vollständig entfernt werden. Dabei erfolgt auch eine Trennung des frontseitigen Emitters **7** in den verbleibenden Zellverbindungsbereichen **12.** Dieser Prozeßschritt ist mit einer Siliziumscheibensäge leicht zu realisieren. Der Wafer **1** liegt mit seiner Rückseite auf einem drehbaren Sägetisch mit Vakuumansaugung. Die zur Entfernung des Materials zwischen den Unterzellen erforderliche Justierung kann automatisch anhand der frontseitigen Emitterkontaktfinger **5** von Digitalkameras vorgenommen werden. Eine Sägemaschine mit einer Spindel, auf welche die entsprechende Anzahl von Trennsägeblättern montiert sind, fährt über den Wafer. Bevor eine vollständige Zelltrennung über die gesamte Waferbreite erreicht ist, verändert die Spindel ihre Schnitthöhe, um in den verbleibenden Zellverbindungsbereichen **12** den Emitter bis in eine Tiefe von einigen 10 µm zu durchtrennen. Das selbe wiederholt sich nach einer Drehung des Vakkumtisches um 180° bei einer um eine Unterzellenbreite versetzten Position der Spindel. Das Resultat nach Beendigen des Ausdünnens des Wafers **1** kann als ein mäanderförmiges Band von langgezogenen Solarzellen angesehen werden.
12.In einem letzten Prozeßschritt kann eine Antireflexionsbeschichtung auf der Zellvorderseite aufgebracht werden.

An der beschriebenen Ausführungsform sind Variationen möglich. So können zu einer weiteren räumlichen Separation von rückseitigem Emitter **8** und Basiskontaktmetallisierung **6** zweier benachbarter Unterzellen auch rückseitige Gräben **3** (**Fig**.3) verwendet werden. Diese sind vorzugsweise bereits vor dem Defekt-Ätzschritt (Prozeßschritt1) in den Wafer einzubringen.

Weiter kann auf die Ausbildung von Einbuchtungen **4** verzichtet werden, wenn statt dessen Löcher **13** zur Verbindung des frontseitigen Emitters 7 mit der Rückseite verwendet werden; dabei ist in **Fig**.4 zur vereinfachten Darstellung nur jeweils ein großes Loch eingezeichnet. Die Löcher lassen sich sowohl mit Sägetechniken, z.B. kreuzweise beidseitiges Sägen, als auch unter Einsatz von gepulsten Lasern oder Ultraschallbohrer in per se bekannter Weise realisieren.

Es ist auch möglich, das erfindungsgemäße Konzept mit der Emitter-Wrap-Through-Technik zu verwenden. Dabei wird der frontseitige Emitter **7** durch viele kleine Löcher **13,** welche über die gesamte Unterzelle verteilt sind, auf die Rückseite durchkontaktiert, wie in **Fig**.5 gezeigt, wobei zur Vereinfachung nur die Position einiger Löcher schematisch und stark vergrößert angegeben ist. Die Löcher sind auch auf der Zellrückseite (**Fig**.6) über streifenförmige Emitter **8** miteinander verbunden. Auf die Emitterstreifen wird die Emitterkontaktmetallisierung **9** aufgedruckt, daneben die Basiskontaktmetallisierung **6**. Es entstehen zwei ineinander greifende Kontaktgrids auf der Zellrückseite. Durch Verwendung vieler über den Wafer verteilter Löcher wird der Weg der Ladungsträger entlang des Emitters zum Metallkontakt verringert und damit der Serienwiderstand einer Unterzelle reduziert. Daher kann bei dieser Ausführungsform auf eine frontseitige Kontaktierung des Emitters eventuell verzichtet werden. Die Herstellung und Verschaltung der Unterzellen verläuft völlig analog zum oben beschriebenen Prozeß.

In einer weiteren, hier nicht beanspruchten Variante können die verbleibenden Brückenstege **12** durch eine isolierende Substanz, welche mit dem Halbleiter eine feste Verbindung eingeht - wie z.B. ein Polyimid - realisiert werden. Dazu werden zuerst die Bereiche des Wafers, in denen die Brückenstege zu liegen kommen sollen, entfernt. Dies kann z.B. in Prozeßschritt 4 erfolgen. Diese Bereiche werden dann nach der Emitterdiffusion mit einem Polyimid zum Teil aufgefüllt. Bei Verwendung eines isolierenden Materials für den gesamten Brückensteg entfallen die Schritte zur Bedekkung des Brückenstegs mit einer Isolator- bzw. Nitridschicht. Ansonsten verläuft der Prozeß analog zum oben beschriebenen.

Die mechanische Stabilität durch die Brückenstege ist absolut ausreichend für eine Zellverarbeitung. Im Fall der Mäandergeometrie erhält der Wafer dabei eine gewisse Elastizität und kann so leicht in sich verwunden werden.

Statt den Emitter wie in Beispiel 1 mittels Einbuchtungen **4** (**Fig**.1-3) oder Löchern **13** (**Fig**.4-6) auf die Rückseite zum Basiskontakt zu führen, kann alternativ der Basiskontakt (Basiskontaktmetallisierung **6)** auf die Vorderseite bzw. die dem Licht zugewandte Seite des Wafers **1** verlegt sein, vgl. **Fig**.7. Dies hat zwar den Nachteil einer größeren Abschattung durch die Metallkontakte für Emitter und Basis, erfordert jedoch keine Verbindung des Emitters **7** durch den Wafer hindurch, was die Prozessierung vereinfacht. Die Prozessierung kann die folgenden Schritte umfassen:
1.In einem ersten Defekt-Ätzschritt werden Oberflächenschäden des Wafers entfernt.
2.Danach wird mittels Phosphordiffusion auf der gesamten Oberfläche eine Emitterschicht erzeugt.
3.Eine Isolatorschicht - z.B. eine Nitridschicht - wird als Schutz vor folgenden Ätzschritten auf den Emitter aufgebracht. Die Regionen, welche als Basiskontakt dienen sollen werden nicht mit der Isolatorschicht bedeckt. Dies läßt sich z.B. durch Verwenden einer Maske während einer PECVD Nitridabscheidung realisieren.
4.Zur elektrischen Isolation der Unterzellen werden von zwei gegenüberliegenden Waferkanten alternierend tiefe Schnitte **14** in den Wafer eingebracht, so daß ein mäanderförmiges schmales Band von langgezogenen Solarzellen entsteht, wobei auch der verbleibende Verbindungsbereich **12** durch einen Graben verjüngt sein kann.
5.Ein anschließender Ätzschritt unter Verwendung von NaOH entfernt die beim Einbringen der Schnitte **14** entstandenen Oberflächenschäden und die Emitterschicht in den nicht mit Nitrid bedeckten Bereichen.
6.Analog zum in Ausführungsbeispiel Nr.1 beschriebenen Verfahren wird nun das Nitrid auf dem Verbindungsbereich **12** zweier Unterzellen durch eine ätzresistente Druckpaste vor dem folgenden Ätzschritt (Flußsäurelösung), welcher zum Entfernen des in Schritt 3 aufgebrachten Nitrids dient, geschützt. Danach kann die ätzresistente Paste beseitigt werden.
7.Anschließend wird die Waferrückseite mit einer möglichst tiefen p⁺⁺ Schicht versehen. Dies ist z.B. durch Siebdruck mit einer Aluminium-Paste und späterer Feuerung realisierbar. In einem zweiten Siebdruckschritt wird das Fingergrid der Basiskontaktmetallisierung **6** frontseitig aufgebracht. Auch hier empfiehlt sich eine aluminiumhaltige Paste zur Erzeugung einer p⁺⁺ Region unter den Fingern. Daraufhin erfolgt in einem letzten Siebdruckschritt die Emitterkontaktierung **9,** wobei gleichzeitig eine Verbindung **15** mit dem Basiskontaktgrid der benachbarten Unterzelle hergestellt wird. Die verbindende Silberschicht verläuft über der Isolatorschicht **10** über die verbliebenen Verbindungsbereiche (Brückenstege) **12** hinweg. Zum Schluß wird auf der gesamten Vorderseite eine Antireflexionsbeschichtung aufgebracht. Dazu kann wieder eine Nitridschicht verwendet werden, welche zusätzlich eine elektronische Oberflächenpassivierung bewirkt.

Wiederum dient ein Isolator **10** der Vermeidung eines direkten Kurzschlusses an der Unterzellenkante wo sich sonst Basis, Emitter 7 und Kontaktverbindung **15** berühren. Es sind Variationen zum Verfahren möglich. So kann statt des Nitrids auch ein Polyimid oder ein anderer, in Form von Druckpasten vorliegender Isolator zur Verhinderung eines solchen Kurzschlusses verwendet werden.

Ebenfalls in Analogie zum ersten mit dem ersten Prozess veranschaulichten Beispiel kann auf einen Graben im Zellverbindungsbereich **12** verzichtet werden, wenn allein durch das Aufbringen einer Isolatorschicht **10** unter der Kontaktverbindung **15** zweier Unterzellen eine ausreichende räumliche Separation von Emitter und benachbartem Basiskontakt erzielt wird.

Das Maskieren bei der Nitridabscheidung nach der Emitterdiffusion kann unterbleiben, wenn bei einem anschließenden Freilegen der Basiskontaktfläche sowohl die Nitrid- als auch die darunterliegende Emitterschicht mittels Planarisierungswalzensägen entfernt werden (**Fig**.8).

In einer weiteren, hier nicht beanspruchten Variante dieser Ausführungsform können die verbleibenden Verbindungsbereiche (Brückenstege) **12** durch eine isolierende Substanz, welche mit dem Halbleiter eine feste Verbindung eingeht - wie z.B. ein Polyimid - realisiert werden. Dazu werden zuerst die Bereiche des Wafers, in denen die Brückenstege zuliegen kommen sollen entfernt. Dies kann z.B. zwischen den Prozeßschritten 3 und 4 erfolgen. Diese Bereiche werden dann mit einem Polyimid z.T. aufgefüllt. Bei Verwendung eines isolierenden Materials für den gesamten Brückensteg entfallen die Schritte zur Bedeckung des Brückestegs mit einer Isolator bzw. Nitridschicht. Ansonsten verläuft der Prozeß analog zum oben beschriebenen.

Nach **Fig**.9 und 10 sieht eine weitere Variante vor, daß sich bei dem Solarzellenanordnungs-Kleinstmodul sowohl die Basis- **6** als auch die Emitterkontaktmetallisierung **9** der Unterzellen **2** auf der dem Licht abgewandten Waferseite befinden. Entgegen den bisherigen Beispielen wird auf einen frontseitigen Emitter vollständig verzichtet (**Fig**.9). Die Funktionsweise einer einzelnen Unterzelle **2** entspricht der einer "Interdigitated Back-Contact"-Zelle, welche vor allem in photovoltaischen Konzentratorsystemen zur Anwendung kommen. Auf der Unterzellenrückseite sind ineinander greifend zwei Metallisierungsgrids für Emitter- **9** und Basiskontakt **6** aufgebracht. Die Emitterregion **8** befindet sich direkt unter den Metallfingern des Emitterkontaktgrids **9** und ist somit vollständig metallisiert. Die Kontaktgrids bedecken fast die gesamte Zellrückseite; die noch frei bleibenden Flächen sind mit einem Dielektrika bzw. einer Isolatorschicht **10** bedeckt und elektronisch passiviert. Auch die Zellvorderseite, welche frei von jeglicher Metallisierung ist, wird von einem passivierenden Dielektrika **10** bedeckt. Der Verzicht auf einen frontseitigen Emitter verringert die Einsammelwahrscheinlichkeit für Ladungsträger, so daß zur Herstellung des Solarzellenanordnungs-Kleinstmoduls nach dieser Variante ein hochwertiges Halbleiterausgangsmaterial mit entsprechend großer Ladungsträgerdiffusionslänge verwendet werden muß. Ein Vertreter solch hochwertiger Ausgangsmaterialien ist monokristallines Silizium. Besondere Vorteile dieser Ausführungsform sind die potentiell erreichbaren hohen Wirkungsgrade der Unterzellen und damit des Solarzellenanordnungs-Kleinstmoduls sowie die ansprechende Ästhetik des Moduls aufgrund der fehlenden frontseitigen Metallisierungen, was besonders beim Einsatz mit High-Tech"-Konsumgütern wie z.B. tragbare Telefone eine wichtige Rolle spielt.

Eine mögliche Prozeßsequenz zur Herstellung dieses erfindungsgemäßen Solarzellenanordnungs-Kleinstmoduls lautet wie folgt:
1.Von zwei gegenüberliegenden Waferkanten werden alternierend tiefe Schnitte **14** in den Wafer 1 eingebracht, so daß ein mäanderförmiges schmales Band von langgezogenen Unterzellen entsteht, wobei auch der verbleibende Verbindungsbereich **12** auf beiden Seiten des Wafers durch einen Graben verjüngt ist,
2.Defektätzen des Wafers,
3.Texturierung der Waferoberflächen durch anisotropes Ätzen zur verbesserten Lichteinkopplung und zur Erzeugung des sogenannten "Light-Trapping",
4.Aufbringen eines Dielektrikums **10 -** z.B. einer Nitridschicht - auf beide Seiten des Wafers 1, wobei die Stellen an denen ein Emitter zu liegen kommen soll geschützt werden (z.B. Maskierung des Wafers bei der Nitridabscheidung). Die Verbindungsbereiche **12** der Unterzellen **2** werden dabei ebenfalls mit dem Dielektrikum **10** belegt. Das Dielektrikum sollte zugleich als Antireflexionsbeschichtung dienen können und in der dazu erforderlichen Dicke aufgetragen werden.
5.Emitterbildung **8** an den unbeschichteten Stellen durch z.B. Phosphordiffusion,
6.Basismetallisierung **6** auf das Dielektrikum aufbringen (z.B. Siebdruck mit einer aluminiumhaltigen Paste),
7.Emittermetallisierung **9** auf die unbeschichteten Stellen, sowie Aufbringen der Kontaktverbindungen **15** zwischen den Basis- und Emittergrids benachbarter Unterzellen **2** (z.B. Siebdruck mit einer silberhaltigen Paste). Die Kontaktverbindungen **15** verlaufen dabei über die mit dem Dielektrikum **10** belegten Verbindungsbereiche **12.**
8.Co-Feuern von Emitter- und Basismetallisierung. Der Kontaktfeuerprozeß ist dabei so abzustimmen, daß die Aluminium-Basismetallisierung **6** durch das Dielektrikum **10** hindurch getrieben wird und einen Kontakt zur Zellbasis herstellt, dagegen die silberhaltige Kontaktverbindung **15** das Dielektrikum **10** noch nicht durchdringt.

Die Verjüngung der Verbindungsbereiche **12** zwischen den Unterzellen **2** dient der räumlichen Separation der Zellen, um laterale Ströme durch die Diffusion von Ladungsträgern in die jeweils benachbarten Unterzellen zu verringern. Die Kontaktverbindungen **15** sind analog zu den vorigen Beispielen gestaltet.

Zum Erzielen noch höherer Wirkungsgrade kann die Größe der stark diffundierten Emittergebiete sowie die Fläche der Basismetallkontakte mit der dort herrschenden hohen Rekombination von Ladungsträgern reduziert werden. Dazu wird das Dielektrikum für die Emitterdiffusion nur punktweise geöffnet. Sowohl der Zellemitter als auch die Zellbasis werden über in regelmäßigen Abständen sitzenden Metallisierungspunkte kontaktiert. Die einzelnen Punkte für Emitter- bzw. Basiskontakt werden über zwei ineinander greifende Kontaktgrids elektrisch verbunden, wobei die Gridfinger auf dem Dielektrikum verlaufen. Der Aufbau der Unterzellen entspricht dann dem von sogenannten "Point Contact Solar Cells". Die Herstellung eines Solarzellenanordnungs-Kleinstmoduls mit derart gestalteten Unterzellen kann analog zu der oben angegebenen Prozeßsequenz verlaufen.

Es soll nochmals darauf hingewiesen werden, daß auch andere Geometrien, als die in den Beispielen 1 bis 3 gezeigte Mäanderform möglich sind. Die **Fig**.11a)-11f) sind insofern durchgängig für alle Beispiele einschlägig.

Nach den **Fig**.12-13 sieht eine weitere Ausführungsform des Solarzellenanordnungs-Kleinstmoduls vor, daß die frontseitige Emitterschicht **7** der Unterzellen **2** durch die Schnittbereiche **14** hindurch auf die Waferrückseite geführt. Das Auffüllen des Schnittbereichs **14** mit einem leitfähigen Material (**Fig**.13g) ermöglicht ein direktes Verschalten zweier Unterzellen **2.** Die Vorteile dieser Ausführungsform sind der Verzicht auf zusätzliche Löcher oder Einbuchtungen in den Unterzellen, die großflächige Serienverschaltung zweier Unterzellen und somit geringe Serienwiderstände im Modul, sowie eine sehr gute mechanische Stabilität durch das Auffüllen eines großen Teils der Schnittbereiche.

Eine mögliche Prozeßsequenz zur Herstellung eines solchen Solarzellenanordnungs-Kleinstmoduls ist:
1. Aufbringen einer Diffusionsbarriere (z.B. einer Nitridschicht **10)** als Streifen (z.B. durch Auflegen von Masken in einem PECVD-Reaktor) entlang der späteren Schnittbereiche **14** (**Fig**.13a).
2. Einbringen der Schnittbereiche **14** an den Diffusionsbarrieren entlang (**Fig**.13b).
3. Defektätzen des Wafers und der Schnittbereiche, wobei die Diffusionsbarriere größtenteils erhalten bleibt. Dies ist im Fall einer Nitridschicht **10** z.B. durch Ätzen mit NaOH zu erreichen.
4. Emitterbildung, z.B. durch Phosphordiffusion. Über die Schnittbereiche stehen dann vorder- und rückseitiger Emitter **(7** und **8)** miteinander in Verbindung, lediglich unter der Diffusionsbarriere verbleibt ein Streifen ohne Emitter (**Fig**.13c). Beim anschließenden herunterätzen des Phosphorglases mit HF wird auch die Diffusionsbarriere entfernt (**Fig**.13d).
5. Entfernen der Emitterschicht an jeweils einer Seite der Schnittbereiche **14** durch erneutes, leicht seitlich versetztes Einschneiden in die Schnittbereiche **14** (**Fig**.13e).
6. Aufbringen der Basiskontaktmetallisierung **6** der Unterzellen **2** auf der Waferrückseite, z.B. mittels Siebdruck unter Verwendung einer aluminiumhaltigen Paste. Die anfänglich unter dem Kontakt liegende rückseitige Emitterschicht **8** wird dabei überkompensiert (**Fig**.13f).
7. Aufbringen der vorderseitigen Emitterkontaktfinger **5** und gleichzeitiges Verschalten der Unterzellen, z.B. mittels Siebdruck unter Verwendung einer silberhaltigen Paste. Beim Aufbringen der Kontaktfinger **5** wird auch Paste durch Teile der Schnittbereiche **14** hindurch bis auf die Waferrückseite gedrückt (**Fig**.13g). Ein mit Metall gefüllter Schnittbereich **14** dient dann sowohl als Busbar für eine Unterzelle als auch als Kontaktverbindung **15** zweier Unterzellen. Zusätzlich wird die Stabilität des Wafers verbessert.
8. Kofeuern der Kontakte.
9. Entfernen der Emitterschichten an den äußeren Waferkante und zwischen den nicht metallisierten Bereichen der Waferrückseite, z.B. durch Plasmaätzen. Dabei entstehen Aussparungen **23**, die ein Kurzschließen der Unterzellen an den Rändern ihrer Basiskontakte verhindern(**Fig**.13h).

Prozeßschritt 5 ist hierbei als optional anzusehen, da die dabei entfernte n-Schicht aufgrund der Nitridschicht **10** und der Basismetallisierung **6** nicht in Verbindung mit dem eigentlichen Zellemitter **7** steht und somit inaktiv ist.

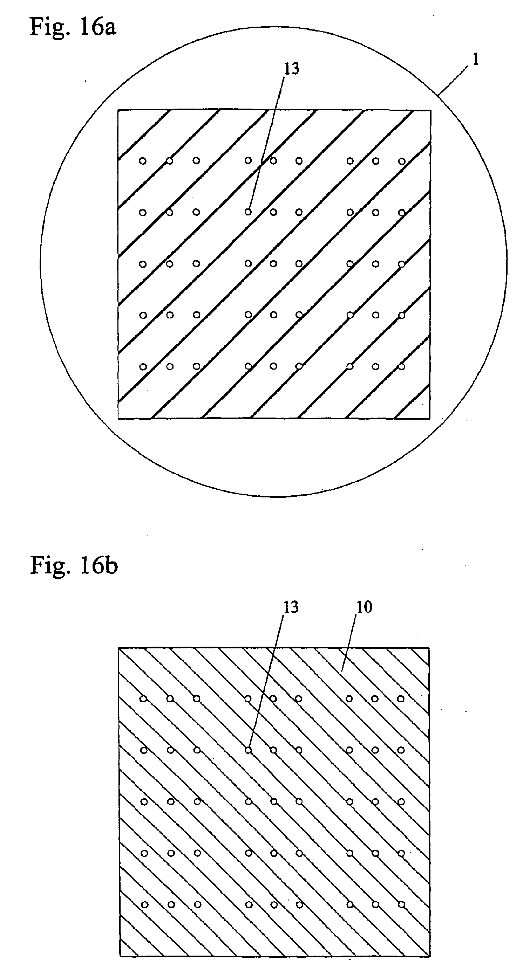

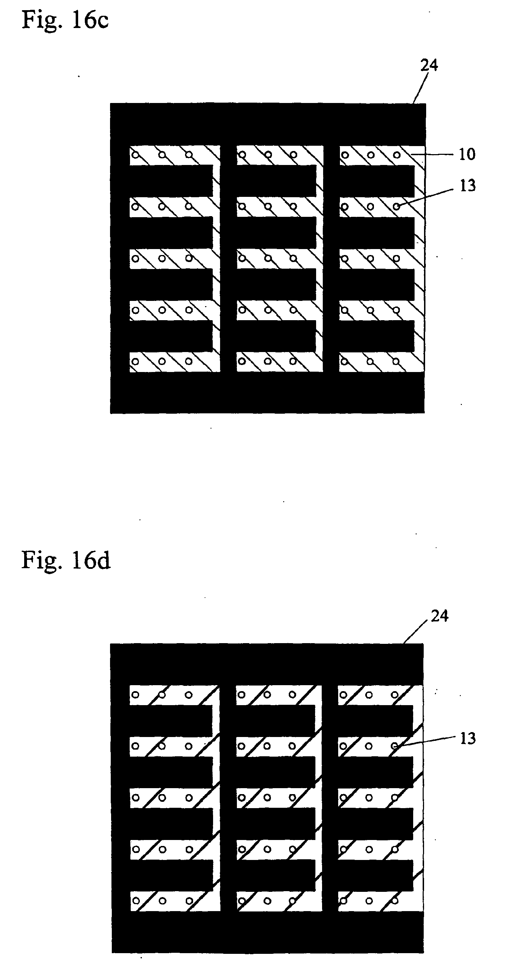

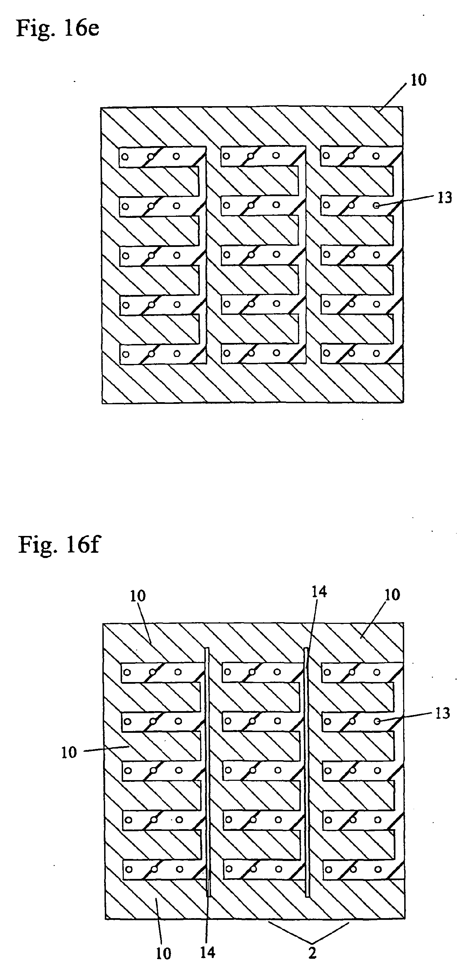

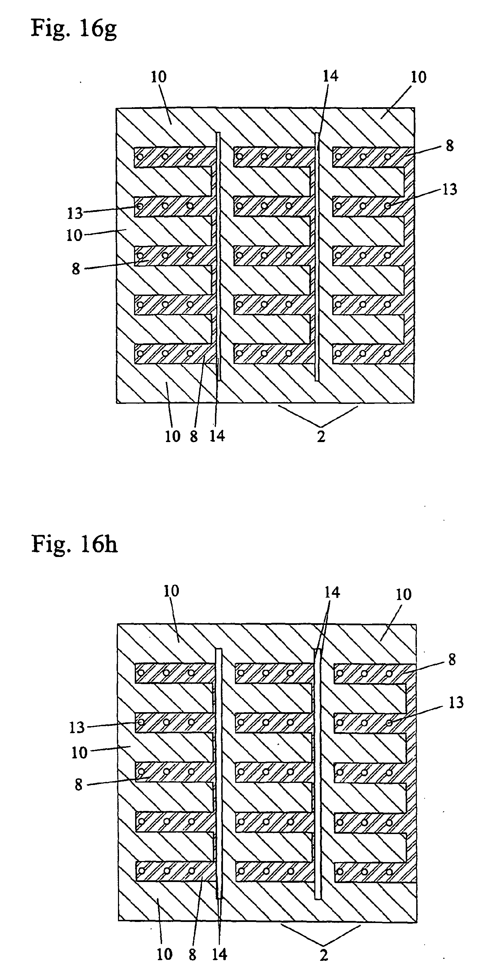

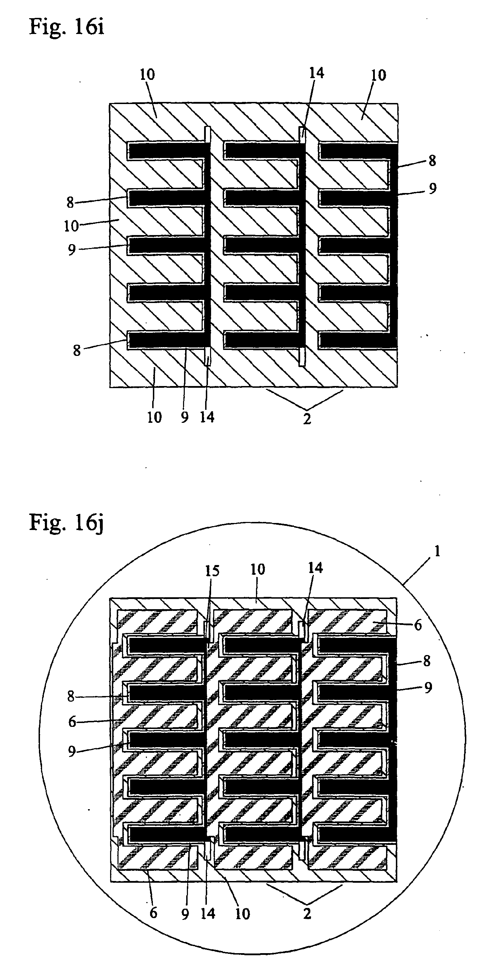

Aus Fig. 16 ergibt sich eine Ausführungsform aus einem EWT-Design des Solarzellenanordnungs-Kleinstmoduls wie folgt. Basis- **6** und Emitterkontaktmetallisierung **9** einer Unterzelle befinden sich jeweils auf der Zellrückseite und bilden ein ineinander greifendes Fingergrid. Die Schnittbereiche **14** (Isolationsgräben) werden beim Aufbringen der Emitterkontaktmetallisierung **9** aufgefüllt, so daß beim darauffolgenden Aufbringen der Basismetallisierung 6 eine Serienverschaltung zweier benachbarter Unterzellen **2** - mittels eines Überlapps der beiden Metallisierungen im Schnittbereich **14 -** erzielt wird. Fig. 16a - 16j veranschaulichen einen möglichen Herstellungsprozeß.

Wie bereits in den Beispielen zuvor, müssen einige Bereiche der Unterzellen vor der Emitterdiffusion geschützt werden. In den bisher beschriebenen Prozeßsequenzen wurden diese Bereiche. mit einer Nitridschicht bedeckt; nitridfreie Bereiche werden durch das Auflegen einer Maske während der Nitridabscheidung erzeugt. In der folgenden Ausführungsform werden aber keine Masken verwendet, sondern es wird zuerst ein ganzflächiges Nitrid aufgebracht, welches anschließend wieder von den mit einem Emitter zu versehenden Regionen durch Ätzen entfernt wird. Die zu verbleibenden nitridbedeckten Bereiche werden dazu selbst mit einem ätzresistenten Siebdrucklack vor dem Ätzen geschützt. Diese Technik wird hier nur beispielhaft beschrieben und ist genauso auf alle anderen Ausführungsformen anwendbar. Ein Herstellungsverfahren ergibt sich damit wie folgt:
1. Laserbohren der Löcher **13,** welche später den frontseitigen Emitter 7 bis zur Zellrückseite führen (Fig.16a).
2. Defektätzen des Wafers.
3.Beidseitiges ganzflächiges Aufbringen einer Diffusionsbarriere (z.B. Nitridschicht **10)** (Fig.16b).
4.Beidseitiges Aufbringen eines ätzresistenten Lackes **24** auf jene Zellregionen, welche wirklich vor der Emitterdiffusion geschützt werden sollen. Dies sind wie in Beispiel 4 ein schmaler Streifen auf der Zellvorderseite entlang der Schnittbereiche, sowie - verändert gegenüber Beispiel 4 - die Regionen des späteren Basiskontakts auf der Zellrückseite (Fig.16c).
5. Entfernen der Diffusionsbarriere (Nitridschicht **10)** von den mit einem Emitter zu versehenden Bereichen durch Ätzen (z.B. Ätzen mittels Freon in einem Plasmaätzreaktor) (Fig.16d).
6.Entfernen des ätzresistenten Lackes mit Lösungsmitteln (Fig.16e).
7.Einbringen der Isolationsschnitte (Schnittbereich **14)** an den Rändern der frontseitigen Diffusionsbarrieren entlang (vgl. auch Beispiel 4) (Fig.16f).
8. Defektätzen der Isolationsschnitte (z.B. mittels NaOH).
9.Emitterbildunq (z.B. durch Phosphordiffusion) (Fig.16g).
10.Entfernen der Emitterschicht von jeweils einer Seite der Schnittbereiche **14** durch erneutes, leicht seitlich versetztes Einschneiden in die Schnittbereiche **14** (vgl. auch Beispiel 4) (Fig.16h).
11.Aufbringen der Emitterkontaktmetallisierung **9** auf die rückseitigen Emitterbereiche **8** z.B. mittels Siebdruck unter Verwendung einer silberhaltigen Paste. Die Löcher **13** sowie die Schnittbereiche **14** werden dabei mit Metall aufgefüllt (Fig.16i). Ein mit Metall gefüllter Schnittbereich **14** dient dann sowohl als Busbar für eine Unterzelle, als auch teilweise als Kontaktverbindung **15** zweier Unterzellen (Fig.16j).
12.Aufbringen der Basiskontaktmetallisierung **6** auf die nitridgeschützten Bereiche z.B. mittels Siebdruck unter Verwendung einer aluminiumhaltigen Paste (Fig.16j). In den Schnittbereichen **14** kommt es dabei zu einem Überlapp von Emitter- und Basiskontaktmetallisierung zweier benachbarter Unterzellen, so daß sich eine Serienverschaltung der Unterzellen ergibt.
13.Kofeuern der Kontakte. Die aluminiumhaltige Paste der Basiskontaktmetallisierung **6** ätzt sich dabei durch die Nitridschicht **10** und stellt somit den Kontakt zum Basismaterial her.
14.Entfernen der Emitterschichten an den äußeren Waferkanten z.B. mittels einer Wafersäge.

Eine weitere, hier nicht beanspruchte Variante zur Herstellung eines Solarzellenanordnungs-Kleinstmoduls basiert auf der Verwendung eines Trägersubstrats bzw. einer Trägerplatine **16** (**Fig**.17) zur Verschaltung der Unterzellen. Dazu müssen Solarzellen hergestellt werden, deren Emitter- und Basiskontakt auf der Rückseite des Wafers zu liegen kommen. Prinzipiell können die in den vorherigen Beispielen vorgestellten Zelldesigns wie "Emitter-Wrap-Through-" und "Interdigitated Back Contact Solar Cell" zum Einsatz kommen. In diesem Beispiel wird das Emitter-Wrap-Around Zellkonzept angewandt. Bei diesem Konzept (**Fig**.18) wird der vorderseitige Emitter **7** entlang einer Waferkante auf die Rückseite (rückseitiger Emitter **8)** geführt. Auf der Vorderseite werden Kontakfinger, welche auf die Geometrie der zu entstehenden Unterzellen abgestimmt sind, aufgebracht und über die mit einer Emitterschicht versehene Waferkante auf die Rückseite der Zelle geführt. Das bedeutet, daß auch eine Waferkante metallisiert ist. Die Basiskontaktmetallisierung **6** wird streifenförmig entsprechend der späteren Geometrie der Unterzellen aufgebracht, ohne jedoch den rückseitigen Emitterkontakt **9** zu berühren. Das Trägersubstrat **16** (**Fig**.17), auf welches die Solarzelle dauerhaft befestigt werden soll, trägt Leiterbahnen **17,** die eine Verbindung zwischen Basiskontakt **6** und rückseitigem Emitterkontakt **9** der benachbarten Unterzelle schaffen (**Fig**.18). Wird die Zelle auf das Substrat gelötet, so kommt die Zelle aufgrund des Lötmaterials **18** in einer Höhe von mehreren 100µm über den Leiterbahnen **17** zu liegen. Daher kann die Zelle mit einer Siliziumscheibensäge nachträglich in Unterzellen zerteilt werden, welche dann bereits verschaltet und deren Basen vollständig voneinander isoliert sind.

Als Substrat kommen viele Materialien in Frage. Sie müssen lediglich isolieren bzw. in der Lage sein isolierende Schichten und leitende Bahnen zu tragen sowie den Temperaturen beim Verbinden mit der Urzelle standhalten. Zu bevorzugen sind Materialien, auf welchen sich z.B. mittels Siebdruck die Leiterbahnen definieren lassen, da so die Trägersubstrate leicht vom Zellhersteller selbst auf die verschiedene Einsatzbereich abgestimmt werden können. Aber auch eine direkte Erzeugung des Solarzellenanordnungs-Kleinstmoduls auf Leiterbahnplatinen der Elektroindustrie ist möglich.

Dieses Verfahren kennzeichnet sich dadurch, daß es eine einfache großflächige Herstellung sowohl der Unterzellen als auch des Substrats erlaubt, wobei das Verschalten der Zellen durch einen einzigen Schritt (z.B. Löten, Kleben oder Bonden) erfolgt und das Verschalten der Unterzellen vor deren Trennung, wodurch die vergleichsweise aufwendige Handhabung einzelner Unterzellen entfällt, und eine einfache Zelltrennung ohne das Substrat oder die Leiterbahnen zu beschädigen, eine vollständige Isolation der Zellbasen, und eine Integration des Solarzellenanordnungs-Kleinstmoduls in elektronische Platinen und Schaltungen bereits bei seiner Erzeugung möglich wird. Eine durchführbare Prozeßsequenz ist:
1.Defektätzen des Ausgangswafers,
2.Nitridabscheidung auf der Waferrückseite, wobei ein Streifen entlang einer Waferkante mittels frei von einer Nitridschicht bleibt (z.B. durch Verwenden einer Maske in einem PECVD-Reaktor)
3.Emitterbildung (Phosphor-Spray-on, Phosphorpasten-Druck, Phosphordiffusion),
4.Entfernen des Nitrids,
5.Nitridabscheidung frontseitig zur Bildung einer Antireflexionsschicht,
6.Rückkontakt zur Zellbasis aufbringen (Al-Ag Siebdruck zur besseren Verlötbarkeit),
7.Frontkontakte aufbringen (Ag Siebdruck),
8.Emitterkontakt auf Waferkante und Rückseite aufbringen (z.B. Waferkante leicht in Ag Druckpaste eintauchen),
9.Feuern der Kontakte durch das Nitrid hindurch,
10.Aufbringen des Lötmittels **18** auf Teile der Leiterbahnen **17** des Substrats,
11.Aufbringen des Wafers auf das Substrat und Verlöten. Die Lötpaste stellt dabei einen elektrischen Kontakt zur rückseitigen Basismetallisierung **6** sowie der rückseitigen Emittermetallisierung **9** an der Waferkante her,
12.Durchtrennen der Zelle in Unterzellen.

Sollte eine einfache Serienproduktion - vor allem der Substrate - noch größere Toleranzen in der Sägehöhe erfordern, so können die Substrate bereits mit Gräben 19 (**Fig**.19) versehen sein, in welchen die Sägeblätter beim Durchtrennen des Wafers entlang fahren, ohne in das Substrat **16** zu greifen.

Während in den vorherigen Beispielen zum Erreichen einer Serienverschaltung stets Emitter- und Basiskontakt auf eine Waferseite verlegt wurden, sieht eine weitere Variante vor, daß Emitter- und Basiskontakt auf getrennten Waferseiten verbleiben. Dies ermöglicht die Verwendung von kommerziell erhältlichen Solarzellen zur Erzeugung des Solarzellenanordnungs-Kleinstmoduls. Aufgrund möglicher negativer Folgen bei einem Durchtrennen von Metallisierungsschichten (z.B. Beeinträchtigung des Trennwerkzeuges, Metallverschleppung an der Schnittkante mit lokaler Kurzschlußbildung am PN-Übergang) sollte der Rückkontakt und die Busbars der Frontgrids nicht durchgängig ausgebildet sein, sondern entsprechend der Streifenform der Unterzellen Unterbrechungen besitzen, entlang deren die Wafer ausgedünnt bzw. getrennt werden können. Dies bedeutet, daß bis auf das Verwenden anderer Metallisierungsdrucksiebe nicht in einen bestehen Zellherstellungsprozeß eingegriffen werden muß.

Die Kontaktierung der Unterzellen wird hierbei wie zuvor bereits beschrieben, vor deren Trennung mit Hilfe eines externen Verschaltungselements vorgenommen; hier erfolgt sie jedoch mit einer seitlich auf eine Kante aufzubringenden Kontaktleiste. Die Innenseite der Leiste beherbergt Leiterbahnen und Kontaktstifte oder metallische Kontaktbügel **20** (**Fig**.20) welche jeweils den Rückkontakt einer Unterzelle mit dem Frontkontakt einer benachbarten Unterzelle verbinden. Auch eine mit Leiterbahnen versehene Folie ist als Leiste bzw. als Teil einer solchen Leiste denkbar.

Bei Verwendung der metallischen Kontaktbügel werden die Bügelenden maschinell auf die Basis- **6** und Emitterkontakte **9** der Unterzellen gelötet. Das Gehäuse der Leiste **22** kann mit entsprechenden Aussparungen versehen sein, um das Erreichen der Bügel mit Lötspitzen zu gewährleisten. Es ist einsichtig, daß auch andere Verbindungstechniken wie Schweißen oder Kleben mit einem Leitkleber eingesetzt werden können. Jeder einzelne Kontaktbügel **20** (**Fig**.21) besteht in dieser Ausführungsform aus einem Bügel, der die Kante umfaßt, sowie einem senkrecht dazu liegenden Metallstreifen, welcher die Rückseite einer benachbarten Unterzelle kontaktiert. Jeder Kontaktbügel **20** weist eine Lasche **21** auf, durch welche die Trennwerkzeuge wie z.B. Sägeblätter zum Herstellen der Unterzellen geführt werden können. Diese Laschen **21** sorgen gleichzeitig für eine mechanisch flexible Verbindung der Unterzellen untereinander. Entsprechend ist die Stirn- und Oberseite des Leistengehäuses **22** unterbrochen (Aussparungen **23),** um ein Trennen des Wafer-Grundmaterial in Unterzellen z.B. mittels Wafersägen zu ermöglichen. Zwei Leisten an gegenüberliegenden Kanten geben dem Kleinstmodul eine erhöhte Stabilität, sowie einen erniedrigten Serienwiderstand und eine gewisse Redundanz bei möglicherweise fehlerhafter Ausführung einer Lötverbindung.

Auf die Laschen **21** kann verzichtet werden, wenn wie in Beispiel 6 das Wafer-Grundmaterial durch Lötmaterial einige 100 µm über seiner Auflagefläche zu liegen kommt und die Sägeblätter beim Trennen über die Bügelenden hinwegfahren.

Unter Verwendung langer Kontaktleisten, welche es ermöglichen mehrere Ausgangswafer bzw. Urzellen zu umschließen, lassen sich Verschaltungen mehrere Kleinstmodule (z.B. Serienverschaltung zu sogenannten "Strings") bereits bei deren Herstellung realisieren.

## Patentansprüche

1. Solarzellenanordnung aus serienverschalteten Solar-Unterzellen (2), die aus einem gemeinsamen Halbleiterwafer-Grundmaterial gebildet sind, in welchem eine Vielzahl von Ausnehmungen (14) zur Abgrenzung der einzelnen, in Serie verschalteten Solar-Unterzellen vorhanden sind, wobei sich zumindest einige der Ausnehmungen von der Oberseite der Solarzellenanordnung bis zu deren Unterseite durch die Solarzellenanordnung hindurch erstrecken, **dadurch gekennzeichnet, dass** in Fortsetzung der Ausnehmungen zur seitlichen Solarzellenanordnungskante hin an dieser Brückenstege (12) aus dem Halbleiterwafer-Grundmaterial belassen sind, um die Solar-Unterzellen über die so belassenen Brückenstege mechanisch miteinander zu verbinden.

2. Solarzellenanordung aus serienverschalteten Solar-Unterzellen nach dem vorhergehenden Anspruch, **dadurch gekennzeichnet, daß** für Emitter (8) und Basis je mindestens ein Fingergrid vorhanden ist.

3. Solarzellenanordung aus serienverschalteten Solar-Unterzellen nach dem vorhergehenden Anspruch, **dadurch gekennzeichnet, daß**
auf einer Seite der Solar-Unterzellen (2) je ein Fingergrid für Emitter und Basis vorgesehen ist.

4. Solarzellenanordung aus serienverschalteten Solar-Unterzellen (2) nach dem vorhergehenden Anspruch, **dadurch gekennzeichnet, daß**
das jeweilige Fingergrid auf der dem Licht abgewandten Seite vorgesehen ist.

5. Solarzellenanordung aus serienverschalteten Solar-Unterzellen (2) nach dem vorhergehenden Anspruch 3, **dadurch gekennzeichnet, daß**
das jeweilige Fingergrid auf der dem Licht zugewandten Seite vorgesehen ist.

6. Solarzellenanordung aus serienverschalteten Solar-Unterzellen (2) nach einem der Ansprüche 2 bis 5, **dadurch gekennzeichnet, daß**
zur Verbindung der Emitter mit dem Emitter-Fingergrid über durch das Halbleiterwafer-Grundmaterial hindurchreichende Löcher und/oder Einbuchtungen am Solarzellenanordnungskante vorgesenen sind, in welchen ein zur Kontaktierung hinreichend leitfähiges Material eingebracht ist und/oder deren Leitfähigkeit auf andere Weise erhöht ist.

7. Solarzelle nach einem der vorhergehenden Ansprüche, **dadurch gekennzeichnet, daß** an den durch die von der Vorder- auf die Rückseite reichenden Ausnehmungen (14) ein bis auf die Zellrückseite reichender Emitter der Solar-Unterzellen (2) ausgebildet ist.

8. Solarzellenanordung aus serienverschalteten Solar-Unterzellen (2) nach einem der Ansprüche 2 bis 7, **dadurch gekennzeichnet, daß** am Fingergrid für Emitter und Basis eine Stromsammelschiene vorgesehen ist, die derart angeordnet ist, daß zwei benachbarte Solar-Unterzellen (2) über eine gemeinsame Stromsammelschiene elektrisch miteinander verbunden sind.

9. Solarzellenanordung aus serienverschalteten Solar-Unterzellen (2) nach dem vorhergehenden Anspruch, **dadurch gekennzeichnet, daß** die Solar-Unterzellen gemeinsame Stromsammelschiene über Brückenstege (12) hinweg verlaufend angeordnet ist.

10. Solarzellenanordung aus serienverschalteten Solar-Unterzellen (2) nach einem der vorhergehenden Ansprüche, **dadurch gekennzeichnet, daß** zwischen allen benachbarten Solar-Unterzellen lediglich die Brückenstege (12) verbleiben.

11. Solarzellenanordung aus serienverschalteten Solar-Unterzellen (2) nach einem der Ansprüche 1 bis 7, **dadurch gekennzeichnet, daß** im Bereich der Brückenstege (12) ein mit dem Halbleitermaterial fest verbundenes isolierendes Material, insbesondere eine Oxidschicht vorgesehen ist, welche den Brückensteg beschichtet.

12. Solarzellenanordung aus serienverschalteten Solar-Unterzellen (2) nach dem vorhergehenden Anspruch und mit einer über die Brückenstege (12) hinweg verlaufenden Stromsammelschiene zur Verbindung der Solar-Unterzellen,
**dadurch gekennzeichnet, daß**
die Stromsammelschiene als über einer Isolatorschicht verlaufende Leiterbahn realisiert ist.

13. Solarzellenanordung aus serienverschalteten Solar-Unterzellen (2) nach einem der vorhergehenden Ansprüche, worin Solar-Unterzellen (2) mit wenigstens zwei unterschiedlichen Flächen vorgesehen sind.

14. Solarzellenanordung aus serienverschalteten Solar-Unterzellen (2) nach dem vorhergehenden Anspruch, worin sich die am Rand angeordneten Unterzellen in der Fläche von den mittleren Unterzellen unterscheiden.

15. Solarzellenanordung aus serienverschalteten Solar-Unterzellen (2) nach einem der vorhergehenden Ansprüche, **dadurch gekennzeichnet, daß** die Brückenstege (12) zum Kontakt mit einer externen Bauteileinheit ausgebildet sind.

16. Solarzellenanordung aus serienverschalteten Solar-Unterzellen (2) nach einem der vorhergehenden Ansprüche, **dadurch gekennzeichnet, daß** Teile des Front- oder Rückkontakts einer Unterzelle (2) durch die Ausnehmungen (14) laufen und hierbei auf Teile des Front- oder Rückkontakts der benachbarten Unterzelle (2) stoßen, um so die Serienverschaltung der Unterzellen (2) herbeizuführen.

17. Verfahren zur Herstellung einer Solarzellenanordung aus serienverschalteten Solar-Unterzellen nach einem der vorhergehenden Ansprüche, **dadurch gekennzeichnet, daß** die Ausnehmungen mittels einer Wafersäge, unter Verwendung eines Laser, durch Drahtsägen, Ätztechniken, Sandstrahlern, Wasserstrahlern, Ultraschallbehandlung oder eine Kombination dieser Techniken erzeugt werden.

18. Verfahren zur Herstellung einer Solarzellenanordung aus serienverschalteten Solar-Unterzellen nach dem vorhergehenden Verfahrens-Anspruch, **dadurch gekennzeichnet, daß** die Ausnehmungen mittels einer Wafersäge erzeugt werden, indem diese stufenweise auf das Halbleiterwafer-Grundmaterial abgesenkt und über diesen hinweg bewegt wird.

19. Verfahren zur Herstellung einer Solarzellenanordung aus serienverschalteten Solar-Unterzellen nach dem vorhergehenden Anspruch, wobei die Wafersäge an einer ersten Stelle auf das Halbleiterwafer-Grundmaterial abgesenkt wird, über dieses bis zu dem Beginn des Brückensteges bewegt wird, mit einer gegebenen Absenkung wenigstens einmal entlang der entstandenen Furche hinweg bewegt wird, und danach weiter abgesenkt und erneut bewegt wird.

20. Verfahren zur Herstellung einer Solarzellenanordung aus serienverschalteten Solar-Unterzellen nach einem der vorhergehenden Verfahrens-Ansprüche, worin eine Wafersäge unter vorzugsweise schneller Drehung gesteuert und/oder geregelt abgesenkt, durch das Halbleiterwafer-Grundmaterial hindurch und dann quer darüber hinweg bewegt wird.

21. Verfahren zur Herstellung einer Solarzellenanordnung aus serienverschalteten Solar-Unterzellen aus einem gemeinsamen Halbleiterwafer-Grundmaterial, **dadurch gekennzeichnet, dass** die Solarzellenanordnung an einem seitlichen Rand zunächst mit einer Kontaktleiste versehen wird, und danach entweder unter Belassung von von der Kontaktleiste zumindest teilweise umgriffener Brückenstege das Halbleiterwafer-Grundmaterial zur Erzeugung von Ausnehmungen, die sich von der Oberseite der Solarzellenanordnung bis zu deren Unterseite durch die Solarzellenanordnung hindurch erstrecken, geschnitten wird, oder nur noch durch die Kontaktleiste gebildete Brückenstege unter vollständiger Durchtrennung des Halbleiterwafer-Grundmaterials erzeugt werden, um die Solar-Unterzellen über die so belassenen Brückenstege mechanisch miteinander zu verbinden.

## Claims

1. Solar cell arrangement comprising series-interconnected solar subcells (2) formed from a common semiconductor wafer base material in which a multiplicity of cutouts (14) for delimiting the individual series-interconnected solar subcells are present, wherein at least some of the cutouts extend from the top side of the solar cell arrangement as far as the underside thereof through the solar cell arrangement, **characterized in that** bridge webs (12) composed of the semiconductor wafer base material are left in continuation of the cutouts toward the lateral solar cell arrangement edge at the latter in order to mechanically connect the solar subcells to one another by means of the bridge webs left in this way.

2. Solar cell arrangement comprising series-interconnected solar subcells according to the preceding claim, **characterized in that** at least one finger grid is present in each case for emitter (8) and base.

3. Solar cell arrangement comprising series-interconnected solar subcells according to the preceding claim, **characterized in that** a finger grid for emitter and base is provided in each case on one side of the solar subcells (2).

4. Solar cell arrangement comprising series-interconnected solar subcells (2) according to the preceding claim, **characterized in that** the respective finger grid is provided on the side remote from the light.

5. Solar cell arrangement comprising series-interconnected solar subcells (2) according to the preceding claim 3, **characterized in that** the respective finger grid is provided on the side facing the light.

6. Solar cell arrangement comprising series-interconnected solar subcells (2) according to any of Claims 2 to 5, **characterized in that** provision is made of holes and/or indentations at the solar cell arrangement edge which extend through the semiconductor wafer base material for the purpose of connecting the emitters to the emitter finger grid and in which a material sufficiently conductive for contact-connection is introduced and/or the conductivity of which is increased in some other way.

7. Solar cell according to any of the preceding claims, **characterized in that** an emitter of the solar subcells (2) which extends as far as the cell rear side is formed at the cutouts (14) extending from the front side to the rear side.

8. Solar cell arrangement comprising series-interconnected solar subcells (2) according to any of Claims 2 to 7, **characterized in that** a busbar is provided at the finger grid for emitter and base, said busbar being arranged in such a way that two adjacent solar subcells (2) are electrically connected to one another via a common busbar.

9. Solar cell arrangement comprising series-interconnected solar subcells (2) according to the preceding claim, **characterized in that** the busbar common to solar subcells is arranged in a manner running across bridge webs (12).

10. Solar cell arrangement comprising series-interconnected solar subcells (2) according to any of the preceding claims, **characterized in that** only the bridge webs (12) remain between all adjacent solar subcells.

11. Solar cell arrangement comprising series-interconnected solar subcells (2) according to any of Claims 1 to 7, **characterized in that** there is provided in the region of the bridge webs (12) an insulating material fixedly connected to the semiconductor material, in particular an oxide layer, which coats the bridge web.

12. Solar cell arrangement comprising series-interconnected solar subcells (2) according to the preceding claim and comprising a busbar for connecting the solar subcells which runs across the bridge webs (12), **characterized in that** the busbar is realized as a conductor track running over an insulator layer.

13. Solar cell arrangement comprising series-interconnected solar subcells (2) according to any of the preceding claims, wherein solar subcells (2) having at least two different areas are provided.

14. Solar cell arrangement comprising series-interconnected solar subcells (2) according to the preceding claim, wherein the subcells arranged at the edge differ from the central subcells in terms of area.

15. Solar cell arrangement comprising series-interconnected solar subcells (2) according to any of the preceding claims, **characterized in that** the bridge webs (12) are formed for contact with an external component unit.

16. Solar cell arrangement comprising series-interconnected solar subcells (2) according to any of the preceding claims, **characterized in that** parts of the front or rear contact of a subcell (2) run through the cutouts (14) and in this case abut parts of the front or rear contact of the adjacent subcell (2) in order thus to bring about the series interconnection of the subcells (2).

17. Method for producing a solar cell arrangement comprising series-interconnected solar subcells according to any of the preceding claims, **characterized in that** the cutouts are produced by means of a wafer saw, using a laser, by wire sawing, etching techniques, sandblasters, water jet machines, ultrasound treatment or a combination of these techniques.

18. Method for producing a solar cell arrangement comprising series-interconnected solar subcells according to the preceding method claim, **characterized in that** the cutouts are produced by means of a wafer saw by the latter being progressively lowered onto the semiconductor wafer base material and moved across the latter.

19. Method for producing a solar cell arrangement comprising series-interconnected solar subcells according to the preceding claim, wherein the wafer saw is lowered onto the semiconductor wafer base material at a first location, is moved over said material as far as the beginning of the bridge web, is moved with a given lowering at least once along the resulting groove, and is then lowered further and moved once again.

20. Method for producing a solar cell arrangement comprising series-interconnected solar subcells according to any of the preceding method claims, wherein a wafer saw is lowered in a manner controlled by open-loop control and/or closed-loop control with preferably rapid rotation, is moved through the semiconductor wafer base material and is then moved transversely across the latter.

21. Method for producing a solar cell arrangement comprising series-interconnected solar subcells composed of a common semiconductor wafer base material, **characterized in that** the solar cell arrangement is firstly provided with a contact strip at a lateral edge, and then either whilst leaving bridge webs at least partly encompassed by the contact strip the semiconductor wafer base material is cut in order to produce cutouts which extend from the top side of the solar cell arrangement as far as the underside thereof through the solar cell arrangement, or bridge webs only formed by the contact strip are produced whilst completely severing the semiconductor wafer base material, in order to mechanically connect the solar subcells to one another by means of the bridge webs left in this way.

## Revendications

1. Système de cellule solaire constitué de sous-cellules solaires (2) raccordées en série, formées d'un matériau de base constitué d'une galette commune de semi-conducteur dans laquelle plusieurs découpes (14) sont prévues pour délimiter les différentes sous-cellules solaires raccordées en série, au moins certaines des découpes s'étendant depuis la face supérieure du système de cellule solaire jusqu'à sa face inférieure en traversant le système de cellule solaire,
**caractérisé en ce que**
en prolongement des découpes jusqu'au bord latéral du système de cellule solaire, des entretoises de pontage (12) constituées du matériau de base de la galette de semi-conducteur sont maintenues pour relier mécaniquement les unes aux autres les sous-cellules solaires par les entretoises de pontage ainsi conservées.

2. Système de cellule solaire constitué de sous-cellules solaires raccordées en série selon la revendication précédente, **caractérisé en ce qu'**au moins une grille de doigts respective est prévue pour l'émetteur (8) et pour la base.

3. Système de cellule solaire constitué de sous-cellules solaires raccordées en série selon la revendication précédente, **caractérisé en ce que** des grilles de doigts sont prévues respectivement pour l'émetteur et pour la base sur une face des sous-cellules solaires (2).

4. Système de cellule solaire constitué de sous-cellules solaires (2) raccordées en série selon la revendication précédente, **caractérisé en ce que** chaque grille de doigts est prévue sur le côté non tourné vers la lumière.

5. Système de cellule solaire constitué de sous-cellules solaires (2) raccordées en série selon la revendication 3 qui précède, **caractérisé en ce que** chaque grille de doigts est prévue sur le côté tourné vers la lumière.

6. Système de cellule solaire constitué de sous-cellules solaires (2) raccordées en série selon l'une des revendications 2 à 5, **caractérisé en ce que** pour relier l'émetteur à la grille de doigts d'émetteur, des trous et/ou des entailles qui traversent le matériau de base de la galette de semi-conducteur et dans lesquels un matériau suffisamment conducteur pour assurer le contact est apporté et/ou dont la conductivité est renforcée d'une autre manière sont prévus sur le bord du système de cellule solaire.

7. Cellule solaire selon l'une des revendications précédentes, **caractérisées en ce qu'**un émetteur des sous-cellules solaires (2) qui s'étend jusqu'à la face arrière des cellules est formé sur les découpes (14) qui s'étendent de la face avant à la face arrière.

8. Système de cellule solaire constitué de sous-cellules solaires (2) raccordées en série selon l'une des revendications 2 à 7, **caractérisé en ce qu'**un rail de collecte de courant qui est disposé de telle sorte que deux sous-cellules solaires (2) voisines sont reliées électriquement l'une à l'autre par un rail commun de collecte de courant est prévu sur les grilles de doigts prévues pour l'émetteur et pour la base.

9. Système de cellule solaire constitué de sous-cellules solaires (2) raccordées en série selon la revendication précédente, **caractérisé en ce que** le rail commun de collecte de courant des sous-cellules solaires est disposé de manière à s'étendre à travers les entretoises de pontage (12).

10. Système de cellule solaire constitué de sous-cellules solaires (2) raccordées en série selon l'une des revendications précédentes, **caractérisé en ce que** seules les entretoises de pontage (12) sont maintenues entre toutes les sous-cellules solaires voisines.

11. Système de cellule solaire constitué de sous-cellules solaires (2) raccordées en série selon l'une des revendications 1 à 7, **caractérisé en ce qu'**un matériau isolant, en particulier une couche d'oxyde, relié solidairement au matériau semi-conducteur et recouvrant les entretoises de pontage, est prévu dans la zone occupée par les entretoises de pontage (12).

12. Système de cellule solaire constitué de sous-cellules solaires (2) raccordées en série selon la revendication précédente et doté d'un rail de collecte de courant qui s'étend à travers les entretoises de pontage (12) pour relier les sous-cellules solaires, **caractérisé en ce que** le rail de collecte de courant est réalisé sous la forme d'une piste conductrice qui s'étend au-dessus d'une couche d'isolant.

13. Système de cellule solaire constitué de sous-cellules solaires (2) raccordées en série selon l'une des revendications précédentes, dans lequel les sous-cellules solaires (2) sont dotées d'au moins deux surfaces différentes.

14. Système de cellule solaire constitué de sous-cellules solaires (2) raccordées en série selon la revendication précédente, dans lequel les sous-cellules disposées sur le bord ont une surface différente de celle des sous-cellules centrales.

15. Système de cellule solaire constitué de sous-cellules solaires (2) raccordées en série selon l'une des revendications précédentes, **caractérisé en ce que** les entretoises de pontage (12) sont configurées pour assurer le contact avec un module externe.

16. Système de cellule solaire constitué de sous-cellules solaires (2) raccordées en série selon l'une des revendications précédentes, **caractérisé en ce que** des parties du contact frontal ou du contact dorsal d'une sous-cellule (2) s'étendent à travers les découpes (14) et viennent ainsi aboutir sur des parties du contact frontal ou du contact dorsal de la sous-cellule (2) voisine pour ainsi permettre le raccordement en série des sous-cellules (2).

17. Procédé de fabrication d'un système de cellule solaire constitué de sous-cellules solaires raccordées en série selon l'une des revendications précédentes, **caractérisé en ce que** les découpes sont formées au moyen d'une scie à galettes, par recours à un laser, par sciage au fil, par des techniques de gravure, par sablage, par projection d'eau, par traitement aux ultrasons ou par une combinaison de ces techniques.

18. Procédé de fabrication d'un système de cellule solaire constitué de sous-cellules solaires raccordées en série selon la revendication de procédé qui précède, **caractérisé en ce que** les découpes sont formées à l'aide d'une scie à galettes en l'abaissant pas-à-pas sur le matériau de base constitué de la galette de semi-conducteur et en la déplaçant sur cette dernière.

19. Procédé de fabrication d'un système de cellule solaire constitué de sous-cellules solaires raccordées en série selon la revendication précédente, dans lequel la scie à galettes est abaissée en un premier emplacement du matériau de base constitué de la galette de semi-conducteur, est déplacée sur celle-ci jusqu'au début de l'entretoise de pontage, est déplacée avec un abaissement donné au moins une fois le long du sillon ainsi obtenu et est ensuite abaissée davantage et de nouveau déplacée.

20. Procédé de fabrication d'un système de cellule solaire constitué de sous-cellules solaires raccordées en série selon la revendication précédente, dans lequel une scie à galettes est abaissée de manière contrôlée et/ou régulée à une rotation de préférence rapide, est déplacée à travers le matériau de base constitué de la galette de semi-conducteur et est ensuite déplacée transversalement par rapport à cette dernière.

21. Procédé de fabrication d'un système de cellule solaire constitué de sous-cellules solaires raccordées en série et formées d'un matériau de base constitué d'une galette commune de semi-conducteur, **caractérisé en ce que** le système de cellule solaire est doté sur un bord latéral d'abord d'une languette de contact et ensuite, le matériau de base constitué d'une galette de semi-conducteur est découpé en laissant des entretoises de pontage chevauchées au moins en partie par la languette de contact pour former des découpes qui s'étendent de la face supérieure de la cellule solaire jusqu'à sa face inférieure en traversant le système de cellule solaire, ou des entretoises de pontage formées par la languette de contact sont formées en découpant complètement le matériau de base constitué de la galette de semi-conducteur pour relier mécaniquement les unes aux autres les sous-cellules solaires par l'intermédiaire des entretoises de pontage ainsi conservées.
